(19) Europäisches Patentamt
European Patent Office
Office européen des brevets

(11) **EP 3 332 433 B1**

(12) **EUROPÄISCHE PATENTSCHRIFT**

(45) Veröffentlichungstag und Bekanntmachung des Hinweises auf die Patenterteilung:
**17.04.2019 Patentblatt 2019/16**

(21) Anmeldenummer: **16732938.2**

(22) Anmeldetag: **10.06.2016**

(51) Int Cl.:
*H01L 51/52* (2006.01)    *H01L 51/56* (2006.01)

(86) Internationale Anmeldenummer:
**PCT/EP2016/000956**

(87) Internationale Veröffentlichungsnummer:
**WO 2017/025158 (16.02.2017 Gazette 2017/07)**

(54) **VERFAHREN ZUM HERSTELLEN OPTOELEKTRONISCH AKTIVER BAUTEILE**

METHOD FOR PRODUCING OPTOELECTRONIC ACTIVE COMPONENTS

PROCÉDÉ DE FABRICATION DE COMPOSANTS OPTOÉLECTRONIQUES ACTIFS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **07.08.2015 DE 102015010077**

(43) Veröffentlichungstag der Anmeldung:
**13.06.2018 Patentblatt 2018/24**

(73) Patentinhaber: **Karlsruher Institut für Technologie (KIT)**
**76131 Karlsruhe (DE)**

(72) Erfinder:
• **EGEL, Amos**
**93059 Regensburg (DE)**
• **KETTLITZ, Siegfried**
**72336 Balingen (DE)**
• **HECHT, Matthias**
**77652 Offenburg (DE)**
• **LEMMER, Ulrich**
**76228 Karlsruhe (DE)**

(56) Entgegenhaltungen:
WO-A2-2008/001241    JP-A- 2006 318 807
JP-A- 2009 272 066

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Verfahren zum Herstellen mindestens eines optoelektronischen aktiven Bauteils mittels Belichtens mit elektromagnetischer Strahlung.

Dieses Verfahren ermöglicht es einerseits, mittels Belichtens mit elektromagnetischer Strahlung durch ein Substrat und eine oder mehrere zusätzliche Elektrodenschichten hindurch eine Struktur in einem Schichtstapel mit mindestens einer optoelektronisch aktiven Schicht und mindestens einer zusätzlichen Elektrodenschicht zu bilden, welcher unter dem Substrat und den Elektrodenschichten, d.h. auf der Seite des Substrats und der Elektrodenschichten, die gegenüber der mit elektromagnetischer Strahlung bestrahlten Seite des Substrat angeordnet sind, aufgebracht ist oder teilweise nach der Belichtung aufgebracht wird. Die aus den dabei gebildeten Strukturen resultierenden optoelektronischen Eigenschaften des Bauteils erlauben andererseits, das Substrat als ein zusätzliches optisches Element zur Lichtstrahlführung bzw. -lenkung im operativen Betrieb zu nutzen.

Mit dem Begriff Elektrodenschicht werden hierbei eine Schicht oder mehrere Schichten bezeichnet, die in transversaler und/oder zum Schichtsystem senkrechter Richtung eine elektrische Leitfähigkeit aufweisen.

In der Druckschrift US 8 125 138 B2 wird eine strukturierte OLED mit Mikrooptiken zum Generieren von gerichtetem Licht offenbart. Hierzu wird eine erste Elektrodenschicht unterhalb einer durchgehenden OLED-Schicht angeordnet und über der durchgehenden OLED-Schicht wird eine strukturierte Isolierschicht derart angeordnet, dass dadurch voneinander getrennte Bereiche gebildet werden, d.h. aktiv abstrahlende (d.h. Licht emittierende) und optisch inaktive Bereiche. Über der strukturierten Isolierschicht wird wiederum eine zweite Elektrodenschicht angeordnet, so dass dadurch eine OLED-Vorrichtung gebildet wird. Über der zweiten Elektrodenschicht wird in einem zuvor bestimmten Abstand eine optisch kollimierende Vorrichtung, wie beispielsweise Linsen, derart angeordnet, dass das von der OLED-Vorrichtung abgestrahlte Licht, jeweils ausgehend von den entsprechenden aktiv abstrahlenden Bereichen, mittels der optisch kollimierende Vorrichtung kollimiert bzw. parallelisiert wird. Jedoch wird in dieser Druckschrift das umgekehrte Verfahren nicht offenbart, welches den Verfahrensschritt aufweist, dass mittels einer optisch kollimierenden Vorrichtung durch Belichtung eine strukturierte OLED hergestellt werden kann. Außerdem wird auch nicht auf den Prozess der Ausrichtung der Linsen zu den Leuchtflächen hierin eingegangen.

In der Offenlegungsschrift DE 198 44 302 A1 ist ein elektrolumineszentes Display offenbart, welches eine optisch transmissives Mittel, d.h. optische Linsen, mit angepasstem Brechungsindex nutzt um das abstrahlende Licht zur Parallelisierung in Richtung des Betrachters zu gewährleisten. Darüber hinaus werden hierin diese Linsen mittels eines Photolacks in einem zusätzlichen Prozessschritt gebildet. Auch in dieser Offenlegungsschrift findet sich kein Hinweis auf ein Verfahren zum Herstellen mindestens eines optoelektronischen aktiven Bauteils, dass mittels eines optisch transmissiven Substrats eine darüber angeordnete optisch aktiven Schichtstruktur derart zumindest teilweise strukturiert wird beim Belichten, dass hierdurch in der optoelektronisch aktiven Schicht mindestens zwei Bereiche mit unterschiedlichen elektrischen bzw. elektronischen Eigenschaften gebildet werden.

In der Druckschrift US 5 666 176 ist ein Verfahren für Flüssigkristallanzeigen mit Dünnschichttransistor-Ansteuerung offenbart, bei welchem Mikrolinsen auf einer Seite des Substrats mittels UV-Licht einen aufgebrachten Photolack derart strukturieren, dass optische Aperturen gebildet werden die zu den Linsen hin ausgerichtet sind, so dass dadurch das Bild auf dem TFT-Displays klarer dargestellt wird. Hierin bezieht sich die Anwendung des offenbarten Verfahrens auf eine Aperturmaske, die lediglich optische Funktionen übernimmt und nicht wie im erfindungsgemäßen Verfahren eingesetzt werden kann ebenso elektronische Funktionen in dem optoelektronisch aktiven Schichtstapel. Darüber hinaus werden in dem Verfahren gemäß dieser Druckschrift ausschließlich ablative Lithographieprozesse offenbart, d.h. es werden insbesondere darin keine Abläufe offenbart, die eine Änderung der elektronischen Eigenschaften hervorrufen können.

In der Druckschrift US 7 011 420 B2 ist eine Festkörperlichtquelle offenbart, welche eine durchgehende OLED-Schichtanordnung aufweist und ein darüber angeordnetes vorgefertigtes Mikrolinsenarray, wobei das Mikrolinsenarray derart darüber angeordnet ist, dass der Brennpunkt der Linsen innerhalb der OLED-Schicht liegt. D.h. auch diese Druckschrift offenbart kein erfindungsgemäßes Verfahren, welches ein Substrat zum Strukturieren mittels Belichtens einer OLED-Vorrichtung nutzt.

In der Druckschrift US 6 570 324 B1 ist ein Monitor offenbart mit einem vorgefertigten Mikrolinsenarray. Die einzelnen Bildpunkte sind bei diesem Monitor selbstleuchtend, d.h. es wird eine Anordnung aus separierten Leuchtelementen gezeigt, wobei die Brennpunktebene der Linsen derart gewählt ist, dass sie genau auf dem unterhalb der Leuchtpixel angeordneten lichtundurchlässigem Substrat liegt. Darüber hinaus werden die Leuchtpixel derart gegenüber den Linsen ausgerichtet, dass sich deren Lichtstrahlen in einem Punkt schneiden. D.h. dass diese Druckschrift jedoch entgegen dem erfindungsgemäßen Verfahren keine Belichtung der anschließend emittierenden Elemente offenbart und außerdem ist gemäß dieser Druckschrift ein Anordnen zwischen Linsen und Leuchtpixeln hierbei unbedingt erforderlich.

In der Druckschrift US 6 967 779 B2 wird ein Verfahren zum Herstellen von Linsen mit darunter angeordneten Aperturen mittels Belichten mit elektromagnetischer Strahlung offenbart, wobei nicht-ablative Prozesse hierbei eingesetzt werden. Diese derart hergestellten Aperturen erfüllen jedoch entgegen dem beanspruchten Verfahren lediglich optische Funktionen. Diese Druckschrift offenbart eben gerade nicht wie im erfindungsgemäßen Verfahren, dass die mittels der Belichtung strukturierten Schicht, insbesondere hinsichtlich deren elektronischen Eigenschaften, anschließend aufgrund zusätzlicher Verfahrensschritte als optoelektronisch aktives Bauteil eingesetzt werden kann.

In den Veröffentlichungen [1] und [2] wird eine OLED beschrieben, deren Leuchtflächen durch eine gestreifte Anode und Kathode strukturiert wurden, welche orthogonal zueinander verlaufen und somit die Leuchtflächen in deren Kreuzungspunkten gebildet werden. Über den besagten Kreuzungspunkten von Anode und Kathode sind in quadratischer Anordnung Mikrooptiken (Linsendurchmesser ca. 50 $\mu$m) zur Lichtkollimation von OLEDs aufgebracht. Durch diesen Aufbau konnte prinzipiell eine Kollimation des von den Leuchtflächen emittierten Lichts erreicht werden. Durch die während der Herstellung notwendige Ausrichtung konnte im Gegensatz zu dem erfindungsgemäßen Verfahren nur auf einer sehr kleinen Fläche eine hinreichend gute Anordnung von Linsen und Leuchtflächen erreicht werden.

In den Veröffentlichungen [3] und [4] wurde eine Kollimation des Lichts einer OLED durch einen sog. "Strahlformer" (engl. Beam-Shaper) erreicht, welcher zusätzlich auf die Lichtemissionsseite einer OLED aufgelegt wird. Dabei handelt es sich um ein transparentes Substrat, auf das eine optisch geschlossene Schicht aus Aluminium in einem Verdampfungsprozess aufgebracht wurde. Anschließend wurden in besagte Aluminiumschicht durch einen lithografischen Ätzprozess in periodischer Anordnung Öffnungen, sog. Aperturen eingebracht. Direkt über der Aluminiumschicht werden Mikrolinsen abgeformt, wobei über jeder Apertur genau eine Mikrolinse angeordnet wurde. Die Ausrichtung zwischen Linsen und Aperturen erfolgte unter einem Maskenpositionierer (engl. Mask Aligner). Die Unterseite der Aperturen ist reflektiv, sodass Photonen, die keine Aperturöffnung treffen, wieder zum OLED-Schichtstapel zurück reflektiert werden und durch die Reflektivität der OLED-Kathode eine erneute Austrittsmöglichkeit durch eine Apertur erhalten. Somit wurden für eine OLED mit aufgelegtem Strahlformer mit kleinen Aperturen höhere Lichtintensitäten in 0°-Richtung gemessen im Vergleich zu derselben OLED ohne Strahlformer. Der Strahlformer wurde dabei nicht in optischen Kontakt mit der OLED gebracht. Es handelt sich bei dem Strahlformer um ein rein optisches Element welches in Verbindung mit einer beliebigen mit Lambert'schen Abstrahlprofil emittierenden OLED eingesetzt werden kann.

Nicht-Patent-Literatur:

[1] P. Melpignano, V. Biondo, S. Sinesi, Michael T. Gale, Susanne Westenhöfer, M. Murgia, S. Caria, and R. Zamboni. Efficient light extraction and beam shaping from flexible, optically integrated organic light-emitting diodes. Applied Physics Letters, 88(15):-, 2006.

[2] P. Melpignano, S. Sinesi, G. Rotaris, M. Antonipieri, F. Cicoira, M.A. Loi, M. Muccini, R. Zamboni, M.T. Gale, and S. Westenhöfer. "Optical coupling of flexible microstructured organic light sources for automotive applications." Synthetic Metals, 139(3):913 - 916, 2003. Proceedings of the Fifth International Topical Conference on Optical Probes of Conjugated Polymers and Organic and Inorganic Nanostructures.

[3] Norbert Danz, Christoph A. Wächter, Dirk Michaelis, Peter Dannberg, and Michael Flämmich. "Micro optical pattern shaping for tailored light emission from organic leds". Opt. Express, 20(12):12682-12691, Jun 2012.

[4] Michael Flämmich, Dirk Michaelis, Norbert Danz, Christoph A. Wächter, Peter Dannberg, and Andreas H. Bräuer. "Micro-optical beam-shaper for tailoring light emission from oleds.", 2010.

JP 2006/318807 offenbart ein Verfahren zum Herstellen einer OLED, wobei ein Substrat mit einer Anordnung von Mikrolinsen belichtet wird, um eine Isolierschicht zu strukturieren und lichtemittierende Bereiche zu formen. In JP 2009/272066 wird ein Verfahren zum Herstellen einer OLED beschrieben, wobei eine Photolackschicht mittels Belichtung durch die darunterliegende Mikrolinsenschicht strukturiert wird. Die Pixels werden durch die strukturierten Photolackschicht voneinander getrennt.

Die Aufgabe besteht darin, ein Verfahren bereitzustellen, in welchem es ermöglicht wird, zwei technische Aufgaben beim Herstellen von optoelektronischen Bauteilen mit geringem technischen Aufwand und Kosten bereitzustellen. Mit anderen Worten besteht die technische Aufgabe einerseits in der Bereitstellung von einer Strukturierung der aktiven Eigenschaften eines optoelektronischen Bauteils und andererseits in der räumlichen Ausrichtung dieser Strukturierung auf lichtablenkende Strukturen.

Eine weitere Aufgabe bei dem erfindungsgemäßen Verfahren ist in der räumlichen Ausrichtung von Mikrolinsen auf eine genaue Position aktiver OLED Flächen zu sehen - und auch hierbei setzt das erfindungsgemäße Verfahren an. Um diese Ausrichtung beispielsweise selbst für großflächige mikrostrukturierte OLEDs zu erzielen, können hierzu erfindungsgemäß beispielsweise die fokussierenden optischen Eigenschaften von angepassten Linsen eingesetzt werden.

Die Aufgabe wird mit einem Verfahren mit den Merkmalen von Patentanspruch 1 gelöst. Hierauf bezogene Unteransprüche geben vorteilhafte Ausgestaltungen wieder.

Ein Vorteil beispielsweise des hier beanspruchten Verfahrens liegt darin, dass es ermöglicht, das Herstellen eines optoelektronisch aktiven Bauteils wesentlich effizienter zu gestalten, d.h. es können innerhalb eines Prozessschrittes somit zwei technische Aufgaben gelöst werden, wodurch die Herstellungskosten und der Zeitaufwand hierfür signifikant reduziert werden können. Darüber hinaus kann eine Ausrichtung der Strukturierung der aktiven Eigenschaften des optoelektronischen Bauteils auf beispielsweise mikroskopische lichtablenkende Strukturen mit sehr hoher Präzision erreicht werden.

Ein mittels des erfindungsgemäßen Verfahrens hergestelltes optoelektronisches aktives Bauteil bzw. ein elektrolumineszentes Bauelement ist beispielsweise eine mittels Mikrolinsen hergestellte strukturierte organische Leuchtdiode, d.h. eine sogenannte OLED, oder eine organische Photodiode, d.h. eine sogenannte OPD, wobei beispielsweise kollimiertes UV-Licht zum Bestrahlen und Strukturieren eines Photolacks, der eine Isolatorschicht bereitstellt, durch die Mikrolinsen hindurch eingesetzt wird. Somit können die Mikrolinsen bereits im Strukturierungsprozessschritt eingesetzt werden und anschließend im operativen Betrieb dazu dienen, das von den erfindungsgemäß derart gebildeten aktiven Schichten der OLED emittierte Licht wiederum durch die Mikrolinsen nach außen hin kollimiert abzustrahlen, was bisher bei flächigen OLEDs ein grundsätzliches technisches Problem darstellte. Darüber hinaus kann mit dem erfindungsgemäßen Verfahren ein optoelektronisches aktives Bauteil hergestellt werden, das zusätzlich auch Effizienzverluste aufgrund von innerer totaler Reflexion verringern bzw. vermeiden kann. Im Fall von OPDs können elektrooptisch aktive Bereiche mit dem erfindungsgemäßen Verfahren derart strukturiert werden, dass erstens der aufgrund eines Lichteinfalles durch die Mikrolinsen erzeugte Stromfluss eine Abhängigkeit vom Einfallswinkel aufweist und zweitens die notwendige Diodenfläche für die Erzeugung eines bestimmten Stromes bei homogener Bestrahlung aus einer bestimmten Richtung durch die Mikrolinsen hindurch geringer ausfallen kann.

Bei OPDs für die Signaldetektion gibt es prinzipiell zwei Gütefaktoren. Einerseits der von einem Lichtsignal erzeugte Stromfluss, andererseits das von der OPD inhärent erzeugte Stromrauschen, welches von der Diodenfläche sowie von der Gesamtmenge an empfangenen Lichtsignalen abhängt. Eine nach dem erfindungsgemäßen Verfahren strukturierte OPD weist aufgrund der Strukturierung erstens eine geringere Diodenfläche auf und zweitens werden aufgrund der Abhängigkeit der Stromerzeugung vom Einfallswinkel des Lichtes störende Lichtquellen außerhalb des Akzeptanzwinkelbereiches diskriminiert.

Die Erfindung ist bspw. auf dem Gebiet der flexiblen organischen Leuchtdioden (sogenannte OLEDs) angesiedelt. Als flächige Leuchtmittel sind insbesondere OLEDs von zwei wesentlichen Problemen betroffen: Erstens, einer verminderten Effizienz auf Grund des sogenannten Wellenleitereffektes, d.h. ein erheblicher Teil des im Bauteil erzeugten Lichtes kann wegen totaler interner Reflexion an der Grenzschicht zwischen Substratmaterial (beispielsweise einer Kunststofffolie) und der umgebenden Atmosphäre, bspw. Luft, nicht aus der OLED heraustreten und trägt deswegen nicht zum nutzbaren Lichtstrom bei.

Zweitens, folgt die winkelabhängige Lichtabstrahlung (d.h. die Leuchtdichte) typischerweise dem Profil einer sogenannten Lambert'schen Abstrahlcharakteristik. Dieses Merkmal der OLEDs wird dann zum Nachteil, wenn für spezifische Anwendungszwecke eine definierte Leuchtdichte in bestimmte Raumrichtungen gewünscht wird, zum Beispiel zur Ausleuchtung eines definierten Beleuchtungsbereiches. Während den annähernd punktförmigen (anorganischen) LEDs durch geeignete Optiken ein gewünschtes Winkelprofil aufgeprägt werden kann, scheidet dieser Ansatz für flächig abstrahlende OLEDs aus. Das flächig emittierte Licht kann nicht verlustfrei in ein definiertes Leuchtdichteprofil gelenkt werden.

Bei der Entwicklung von OLEDs für Beleuchtungszwecke stellen Verluste aufgrund von interner Reflexion einen wesentlichen Verlustmechanismus dar, der die Effizienz dieser Leuchtmittel einschränkt. Insbesondere der vorwärts gerichtete bzw. nach außen gerichtete Anteil des abstrahlenden Lichts ist hierbei auschlaggebend. Mittels Anwendens bzw. Aufbringens von mindestens einer Mikrolinse bzw. einem Array, aufweisend eine Vielzahl von Mikrolinsen, über einem unstrukturierten Substrat oder mehreren unstrukturierten Substraten kann die Gesamtmenge des ausgekoppelten Lichts gesteigert werden. Mittels eines zusätzlich über den Auskopplungsstrukturen angepassten Strukturierens der Emissionsfläche kann gerade der Anteil des nach vorn bzw. außen gerichteten Lichts gesteigert werden. Hierdurch kann die Effizienz gesteigert werden, was wiederum ein wichtiger Faktor für die Herstellung eines optoelektronisch aktiven Bauteils mit dem erfindungsgemäßen Verfahren darstellt.

Neben der Lichtleistung und Effizienz einer Beleuchtungslösung, spielt immer auch die Abstrahlrichtung der Lichtquelle eine entscheidende Rolle. Historisch haben hierfür bisher z.B. Lampenschirme und/oder Reflektoren diese Aufgabe übernommen. Mit dem erfindungsgemäßen Verfahren können bspw. auch besonders flache Beleuchtungslösungen direkt auf dem Substrat der OLED realisiert werden, die mit geringem Aufwand und ohne zusätzliche Optiken beispielsweise als direkte Raumbeleuchtung eingesetzt werden können. Mittels Verwendens eines flexiblen, d.h. bspw. biegbaren, Substrats kann die Abstrahlcharakteristik einer solchen Beleuchtungseinheit mittels nachträglichem Biegen bzw. Verdrehen der Leuchtfläche angepasst werden.

Außerdem kann ein mit dem erfindungsgemäßen Verfahren hergestelltes optoelektronisches aktives Bauteil bzw. elektrolumineszentes Bauelement ebenso im Automotive-Bereich eingesetzt werden, z.B. für die gezielte Ausleuchtung des Innenraums bei verringerter oder gänzlich vermiedener Blendwirkung der Beleuchtung, insbesondere für den Fahrer, bei gleichzeitiger verringerter Einbautiefe und Eigengewicht.

Beispielsweise sind effiziente, gedruckte OLEDs im Fokus derzeitiger Forschung und Entwicklung, wobei insbesondere ein Ziel dabei ist, eine Massenproduktion in Rolle-zu-Rolle-Prozessen bereitstellen zu können. Sowohl bei OLEDs, deren Schichten mittels Aufdampfen prozessiert werden, als auch bei OLEDs, deren Schichten aus der Flüssigphase abgeschieden werden, wäre eine Anwendung des erfindungsgemäßen Verfahrens prinzipiell sofort möglich. Jedoch ist hierfür z.B. das Herstellen von Mikrolinsenarrays über dem Substrat erforderlich, auf dessen den Mikrolinsen gegenüberliegender Seite anschließend die OLEDs hergestellt werden können. Infrage kämen hierfür Abformungsprozesse oder bei Einsatz von flexiblen Substraten auch Prägeprozesse, wie sie z.B. bei der Herstellung holografischer Schichten bereits eingesetzt werden. Das erfindungsgemäße Verfahren stellt hierfür eine geeignete Basis dar, da die oben genannten Prozessschritte in das erfindungsgemäße Verfahren mit integriert werden können.

Die Erfindung betrifft beispielsweise ein Verfahren zur Herstellung von OLEDs, deren Leuchtfläche mikroskopisch strukturiert werden, d.h. vor oder nach Prozessieren gemäß dem beanspruchten Verfahren, so dass bspw. nur bestimmte Teilflächen aktiv leuchten, während andere dunkel bleiben. Das mit einer solchen OLED erzeugte Licht kann dann mit Hilfe von Mikrolinsen am Übergang von Substrat zur umgebenden Luft weitgehend in ein zuvor definiertes Winkelprofil (zum Beispiel Vorwärtsabstrahlung) gebracht werden. Gleichzeitig kann aufgrund einer Vermeidung von totaler interner bzw. innerer Reflexion die Lichtausbeute aus der OLED gesteigert werden.

Da in einer Ausführungsform des erfindungsgemäßen Verfahrens die Strukturierung im Mikrometermaßstab durchgeführt wird, kann eine solche OLED dabei vom menschlichen Auge weiterhin als flächiges Leuchtmittel wahrgenommen werden.

Zum Beispiel ist ein Ausgangspunkt in dem erfindungsgemäßen Verfahren ein mit einem Mikrolinsenraster bestücktes Substrat oder eine mit einem Mikrolinsenraster bestückte Substratfolie, wobei auf deren Gegenseite eine transparente Elektrodenschicht angeordnet wird. Darauf kann dann in einem nicht erfindungsgemäßen Beispiel ein Positiv-Fotolack aufgebracht werden.

Die Begriffe Foto- bzw. Photolack werden in der vorliegenden Schrift synonym verwendet und definieren somit einen Lack mit gleichen Materialeigenschaften.

Von der Linsen-Seite her kann dann paralleles bzw. kollimiertes UV-Licht eingestrahlt werden. Wird bspw. eine an die Geometrie der Linsen angepasste Substrat-Foliendicke verwendet, dann kann sich das eingestrahlte Licht auf der Gegenseite der Substratfolie im Fokus der Linsen bündeln, wobei der Fokus im Inneren der Folie kurz oberhalb der Rückseite liegen kann. Mittels dieser angepasste Fokussierung wird der Fotolack nur in einem begrenzten, d.h. in einem zuvor definierten, Bereich nahe dem Fokuspunkt mit einer ausreichend hoher Intensität belichtet. Nach einer Entwicklung (das entspricht im Fall eines Positivlacks der Entfernung der belichteten Partien durch eine geeignete Entwicklerlösung) kann also die Fotolackschicht anschließend derart strukturiert werden, dass eine Ausrichtung auf die Lage der Mikrolinsen automatisch gewährleistet ist. Der auf den unbelichteten Flächen verbliebene Fotolack kann dabei die Funktion eines elektrischen Isolators erfüllen.

Im nächsten Prozessschritt werden dann beispielsweise die zusätzlichen elektrischen Funktionsschichten einer OLED aufgedampft (oder zum Beispiel aus der Flüssigphase prozessiert). Bei Betreiben einer erfindungsgemäß hergestellten OLED kann der Ladungstransport von der transparenten Elektrode zur Licht generierenden organischen Schicht überall dort vom Fotolack geblockt werden, d.h. unterbunden, wo dieser nicht belichtet worden ist. Auf diese Weise kann also effektiv eine OLED hergestellt werden, die nur nahe dem Fokus der Mikrolinsen Licht erzeugen kann. Deswegen kann das von den aktiven OLED-Flächen erzeugte Licht dann vorzugsweise in jene Richtung abgestrahlt werden, aus welcher beim zuvor erfolgten Belichtungsschritt, bspw. mit UV-Licht, eingefallen ist. In einer solchen Konfiguration kann außerdem die totale interne Reflexion im Akzeptanzbereich der Linsen an der Substrat/Luft-Oberfläche bzw. -Grenzfläche unterdrückt werden, so dass eine gesteigerte Lichtausbeute dadurch erreicht werden kann.

Des Weiteren können anstatt spezifischer OLEDs beliebige flächige Emitter verwendet werden, wobei bspw. deren Emissionsfläche mit dem erfindungsgemäßen Verfahren beispielsweise zusätzlich strukturiert werden können.

Außerdem können zum Beispiel anstatt Linsen auch andere Geometrien bzw. Formen für die mindestens eine Mikrooptik verwendet werden z.B. parabolische Strukturen, linsenähnliche Strukturen oder facettierte Optiken.

Beispielsweise kann die Belichtung auch schräg erfolgen, d.h. unter verschiedenen Einstrahlwinkeln bzw. mit anderen Worten: einem Einstrahlwinkel der nicht gleich dem senkrechten Einfallwinkel auf das Substrat ist bzw. sich von diesem unterscheidet, wodurch die jeweilige Leuchtfläche relativ zu den entsprechenden Linsen verschoben werden und die Emission wiederum schräg erfolgen kann.

Darüber hinaus kann zum Beispiel die Belichtung aus unterschiedlichen Winkeln bzw. mit nicht-parallelen bzw. nicht-kollimierten Lichtstrahlen erfolgen, um einen beliebig definierbaren Emissionsbereich erzeugen zu können.

Der Fotolack kann beispielsweise optisch transparent bzw. transluzent, absorbierend oder reflektierend sein, um so die Eigenschaften des Streulichts zu beeinflussen.

Wird zum Beispiel eine niederbrechende Schicht zwischen Emitter und Linsen eingefügt (z.B. vorzugsweise nahe am Emitter), kann das Winkelprofil der Strahlung im Substrat dahingehend beeinflusst werden, dass schräge Lichtstrahlen unterdrückt werden. Die verbleibenden schräg nach vorn gerichteten Lichtstrahlen können durch die Linsen besser nach vorn ausgekoppelt werden, Streulicht hingegen wird hierdurch unterdrückt.

Wird zum Beispiel auf einer Rückseite der niederbrechenden Schicht eine Streuschicht eingefügt bzw. aufgebracht, kann die Leuchtdichte des Emitters durch sogenanntes Lichtrecycling noch gesteigert werden.

In einer Ausführungsform wird zum Beispiel bevorzugt die reflektierende Rückelektrode aufgeraut bzw. strukturiert.

Der Übergang zur niederbrechenden Schicht kann beispielsweise derart aufgeraut bzw. strukturiert werden, dass hierdurch eine zusätzliche Streuung generiert werden kann.

In weiteren Ausführungsformen können beispielsweise zusätzlich Partikel in aktive und/oder passive Schichten eingebracht werden.

Das optoelektronisch aktive Schichtsystem kann auch beispielsweise eine Photodiode darstellen. Beim Einsatz von beispielsweise fokussierenden Strukturen auf dem Substrat kann in einem nicht erfindungsgemäßen Beispiel durch den Einsatz eines isolierenden Fotolackes und Belichtung mit kollimierter elektromagnetischer Strahlung ein Bauteil erzeugt werden, dessen optoelektronisch aktive Eigenschaften derart strukturiert sind, dass die Photodiode nur im Fokusbereich der lichtführenden Strukturen sensitiv ist, so dass im operativen Betrieb eine winkelabhängige Empfindlichkeit und bei kollimierter Beleuchtung ein verbessertes Signal-zu-Rausch Verhältnis erzielt werden kann.

Im Folgenden werden zunächst die bislang bestehenden Lösungsansätze für eine erhöhte Lichtauskopplung aus flexiblen OLED Substraten kurz erläutert und anschließend bestehende Lösungen für das Erzeugen von gerichtetem Licht aus OLEDs.

Bei konventionellen Herstellungsprozessen besteht die umfassendste Maßnahme zur Extraktion bzw. Lichtauskopplung von "gebundenem" Licht aus OLED Substraten in einem sogenannten Makroextraktor. Dies ist ein optisches Element mit einem Brechungsindex, der dem des jeweils eingesetzten Substrates angepasst ist. Der Makroextraktor kann zum Beispiel die Form einer Halbkugel oder eines trapezförmigen Polyeders aufweisen, seine Abmessungen müssen jedoch die der Leuchtfläche um ein vielfaches übersteigen. Dieser Ansatz wird für die beinahe punktförmigen (anorganischen) LEDs sehr oft eingesetzt. Weitere Möglichkeiten zur Lichtextraktion sind beispielsweise ein Aufrauen der Substratoberfläche, Aufbringen von Mikrostrukturen wie Linsen oder Pyramiden oder auch Streuschichten auf der Grundlage von Nano- oder Mikropartikeln. Diese Methoden beruhen jeweils auf der Idee, die Lichtausbreitungsrichtung im OLED-Substrat durch Zufallsstreuung zu "randomisieren", so dass ein erhöhter Teil des Lichtes (ggf. nach Reflexion am spiegelnden OLED-Schichtsystem) aus dem Substrat tritt.

Die Verwendung eines Makroextraktors ist bei annähernd punktförmigen Lichtquellen wie z.B. einer LED sinnvoll und gängige Praxis. Bei ausgedehnten Flächenstrahlern wie den OLEDs ist dieses Verfahren jedoch ungeeignet, da die Größe des Makroextraktors die Größe der Leuchtfläche deutlich übersteigen muss.

Um gerichtetes Licht aus OLEDs zu erhalten wurde beispielsweise der Ansatz, Optiken im Milli- oder Mikrometermaßstab auf das Substrat einer strukturierten OLED zu bringen, im Kontext des sogenannten "Beam-Shapings" für OLEDs bereits in mehreren Publikationen vorgeschlagen. Die ersten Veröffentlichungen nutzen zur Strukturierung eine Anoden-Kathoden-Matrix mit einer dazwischenliegenden optisch aktiven Schicht, in deren Kreuzungspunkten einzelne Leuchtflächen entstehen. Oberhalb dieses quadratischen Leuchtpunktrasters sind Mikrolinsen angeordnet, welche durch lithografische Methoden am Leuchtpunktraster ausgerichtet wurden. Dieser Prozess ist unter Laborbedingungen im kleinen Maßstab gut realisierbar, lässt sich jedoch nur mit großem Aufwand in die Massenfertigung übertragen und ist für Rolle-zu-Rolle-Prozesse gänzlich ungeeignet.

Zur Verbesserung der Lichtauskopplung von OLEDs sind Mikrolinsen eine weitreichend untersuchte und funktionierende Methode. Auch ohne Strukturierung der Leuchtfläche werden Substratmoden unterdrückt und es kann somit mehr Licht ausgekoppelt werden. Jedoch wird bei diesem Ansatz in der optisch aktiven Schicht auch Licht außerhalb des Akzeptanzbereichs der Linsen emittiert. Dieses Licht kann zu einigen Teilen nicht direkt am Übergang zwischen Linsen und Außenbereich, bspw. Luft, ausgekoppelt werden, sondern wird aufgrund von Totalreflexion an diesem Übergang wieder Richtung Kathode zurückreflektiert. Dort können Teile des Lichts erneut reflektiert werden und haben somit eine erneute Austrittswahrscheinlichkeit. Die Reflektivität und Transmittivität des OLED Stacks ist jedoch nicht perfekt. Es werden somit auch große Teile des Lichts innerhalb der OLED absorbiert und gehen als Wärme verloren. Des Weiteren kann mit diesem Ansatz aufgrund der sogenannten Etendue-Erhaltung kein signifikanter Einfluss auf die Winkelverteilung der Lichtemission genommen werden.

Die Etendue E (frz.: ausgebreitet) misst die Ausdehnung eines Strahlenbündels in der geometrischen Optik. Die Etendue setzt sich aus dem Querschnitt und dem Raumwinkel zusammen. Für ein infinitesimales Strahlenbündel ist die infinitesimale Etendue definiert als:

$$dE = \left(d\vec{a} \cdot \vec{k}\right)d\omega$$

wobei $\omega$ der Raumwinkel, $\vec{a}$ der Flächenvektor des Querschnitts und $\vec{k}$ der auf den Brechungsindex normierte Richtungsvektor der Strahlung ist.

Die Etendue ist eine Erhaltungsgröße der geometrischen Optik, ändert sich also nicht beim Durchgang eines Strahlenbündels durch ein optisches System. Sie ist eine sogenannte Lagrange-Invariante.

Für ein abbildendes System wird die Etendue auch als Lichtleitwert bezeichnet und misst die Etendue der maximal übertragenen Strahlung.

Für nicht abbildende Systeme, wie sie in der Beleuchtungstechnik anzutreffen sind, beschreibt die Etendue einer Lichtquelle, wie stark das Licht bereits aufgefächert ist, d.h. hat eine Lichtquelle wie z.B. eine Leuchtstofflampe eine entsprechend große Etendue, kann daraus - wenn keine Lichtleistung verloren gehen soll - eng gebündeltes Licht nur mit einem extrem großen Reflektor erzeugt werden.

Eine Punktlichtquelle wie eine Halogenmetalldampflampe hat eine wesentlich kleinere Etendue und erlaubt somit die gerichtete Abstrahlung großer Teile des Lichts mit einem relativ kleinen Reflektor.

Zur Erzielung eines bestimmten Winkelprofils bei der Lichtemission von OLEDs gibt es bereits mehrere Veröffentlichungen. Dabei weisen diese Veröffentlichungen die Merkmale einer strukturierten oder teilabgeschatteten Leuchtfläche mit darüber liegenden, auf die Leuchtbereiche ausgerichteten Mikrooptiken auf. Jedoch sind alle bisherigen Versuche nur unter Laborbedingungen und unter großem Aufwand reproduzierbar, da die Ausrichtung der Mikrooptiken zu den Leuchtflächen im Mikrometermaßstab immer manuell unter dem Mikroskop erfolgen muss.

Hingegen wird in der vorliegenden Erfindung die Ausrichtung zwischen Linsen und Strukturierung der Leuchtfläche mittels einer Belichtung mit elektromagnetischer Strahlung durch die für die Auskopplung genutzte mindestens eine Linse hindurch erreicht. Aufgrund der frei wählbaren Lichtverteilung bei dieser Beleuchtung, können beispielsweise unterschiedliche Abstrahlprofile für den Flächenstrahler erzielt werden.

Dieser erfindungsgemäße Prozess ist z.B. im Vergleich zu den anderen konventionellen Prozessen in großem Maßstab bei vergleichbar geringem Aufwand und Kosten realisierbar und somit auch für die Massenfertigung wie z.B. Rolle-zu-Rolle-Prozesse geeignet. Auch große Leuchtflächen können bspw. so strukturiert und auf die Auskoppeloptiken ausgerichtet werden, ohne dass ein "Auseinanderlaufen" der Ausrichtung von Linsen- und Leucht-Strukturen zu befürchten wäre. Aufgrund der elektrisch isolierenden Wirkung der mindestens einen Schicht wird die OLED nur in den Akzeptanzbereichen der mindestens einen Mikrooptik elektrisch leitend gebildet. Dies erhöht den Gesamtwirkungsgrad der OLED signifikant.

Eine Ausführungsform der vorliegenden Erfindung bezieht sich auf ein Verfahren zum Herstellen mindestens eines optoelektronischen aktiven Bauteils mittels Belichtens mit elektromagnetischer Strahlung, aufweisend: Bereitstellen mindestens eines Substrats mit einer Oberseite und einer Unterseite, wobei sich die Oberseite und die Unterseite gegenüberliegen, wobei das Substrat mittels mindestens einer Schicht oder einem Schichtstapel, bestehend aus mindestens zwei übereinander angeordneten Schichten, gebildet ist, wobei die Unterseite des Substrats mindestens eine erste Elektrodenschicht aufweist, wobei die Oberseite mindestens eine Struktur aufweist, und wobei das Substrat und die erste Elektrodenschicht derart eingerichtet sind, dass das Substrat und die erste Elektrodenschicht zumindest gegenüber einem Wellenlängenbereich der elektromagnetischen Strahlung transparent oder transluzent sind; Aufbringen mindestens einer zusätzlichen ersten Schicht über der ersten Elektrodenschicht, wobei die erste zusätzliche Schicht derart eingerichtet ist, dass sie die elektromagnetische Strahlung zumindest teilweise absorbiert; Belichten der zusätzlichen ersten Schicht durch das Substrat und die erste Elektrodenschicht hindurch mit der elektromagnetischen Strahlung, wobei die elektromagnetische Strahlung beim Auftreffen auf die Struktur gebrochen oder gebeugt wird, wodurch mindestens zwei Bereiche mit unterschiedlicher Belichtungsintensität in der zusätzlichen ersten Schicht gebildet werden; und Aufbringen mindestens einer zusätzlichen zweiten Elektrodenschicht zumindest teilweise über der zusätzlichen ersten Schicht.

In einer weiteren Ausführungsform weist die Struktur eine Oberfläche mindestens einer fokussierenden Mikrolinse auf.

Linsen haben einen klar definierten Fokuspunkt für kollimiertes Licht und strahlt von diesem Fokuspunkt ausgehendes Licht kollimiert ab. Mikrolinsen haben geringe Höhen und deswegen geringere Fokuslängen, wodurch dünne Bauteildicken ermöglicht werden. Somit sind aber auch dünne Substrate erforderlich, wodurch die Gesamtausdehnung solcher Aufbauten geringer ausfallen gegenüber konventionellen Leuchtmitteln. Diese Eigenschaften sind bei OLEDs generell gegeben.

In einer weiteren Ausführungsform weist jede der mindestens einen Mikrolinse eine Brennweite gleich dem jeweiligen Abstand zwischen Oberseite und Unterseite des Substrats im Bereich der jeweiligen Mikrolinse von plus minus 25% auf.

Der Fokuspunkt liegt dabei auf der aktiven Schicht, damit die benötigte Intensitätsvariation erreicht werden kann.

In einem nicht erfindungsgemäßen Beispiel wird die mindestens eine zusätzliche Schicht mit einem Negativlack oder einem Positivlack gebildet, und wobei zumindest teilweise einer der Bereiche mit unterschiedlicher Belichtungsdosis vor dem Aufbringen der zweiten Elektrodenschicht selektiv entfernt wird, so dass in diesem Bereich die jeweils darunter liegende Schicht zumindest teilweise freigelegt ist.

Ein entwickelter Photolack ist üblicherweise elektrisch isolierend und optisch im sichtbaren Bereich transparent und kann deshalb in der Struktur verbleiben. Der elektrisch isolierende Photolack kann eine direkte Strukturierung der elektrischen Eigenschaften bewirken.

In einem weiteren nicht erfindungsgemäßen Beispiel wird die erste Schicht nur bei einer der beiden unterschiedlichen Belichtungsintensitäten bei der Belichtung thermisch vor dem Aufbringen der zweiten Elektrodenschicht selektiv entfernt, d.h. z.B. ablativ, wodurch die jeweils darunter liegende Schicht zumindest teilweise freigelegt ist.

Anstatt eines Photolackes kann bspw. auch direkt ablativ gearbeitet werden, wodurch möglicherweise der sonst notwendige Entwicklungsschritt entfallen kann. Das kann potentiell eine billigere bzw. vereinfachte Herstellung ermöglichen.

Erfindungsgemäß wird die elektrische Leitfähigkeit der ersten Schicht in deren Volumen und/oder am Übergang zu mindestens einer angrenzenden Schicht geändert. Anstatt elektrisch isolierender Eigenschaften könnte auch mindestens eine zusätzliche dünne Schicht eines zuvor bestimmten Materials strukturiert werden, welches seine Leitfähigkeit und/oder seine Oberflächeneigenschaften bei Bestrahlung ändert. Das ermöglicht potentiell eine billigere bzw. vereinfachte Herstellung.

In einer weiteren Ausführungsform erfolgt die Belichtung der Struktur mit einer kollimierten elektromagnetischen Strahlung. In vielen Anwendungen ist es erforderlich, dass Lichtquellen ein bestimmtes Abstrahlprofil bekommen sollen. Demgemäß wird erfindungsgemäß z.B. eine gerichtete Abstrahlung beabsichtigt. Durch die Linsen hindurch wird kollimiertes Licht in einen Fokuspunkt geleitet, der gleichzeitig die aktive Fläche der Lichtquelle darstellt, wodurch das von der Lichtquelle emittierte Licht auch wieder ein entsprechendes winkelmäßig schmales Abstrahlprofil in der entsprechenden Richtung erhält.

In einem nicht erfindungsgemäßen Beispiel erfolgt die Belichtung der Struktur einem zuvor bestimmten unveränderlichen Einstrahlwinkel.

Erweiterung für schräge Abstrahlung, z.B. um bei flächiger Deckenbeleuchtung gezielt eine Wand schräg zu bestrahlen bzw. anzustrahlen.

Erfindungsgemäß sind die Intensitäten der Belichtung über der generierten Struktur inhomogen.

Hiermit wird eine örtliche Intensitätsverteilung der Abstrahlung erreicht und damit kann z.B. ein leuchtender Schriftzug dargestellt werden.

Erfindungsgemäß erfolgt die Belichtung abhängig vom Ort mit unterschiedlichem Einstrahlwinkel und/oder unterschiedlicher Intensität.

Hiermit wird je nach Betrachtungswinkel zu dem optoelektronischen aktiven Bauteil eine andere örtliche Intensitätsverteilung bereitgestellt, wie z.B. je nach Betrachtungswinkel unterschiedliche leuchtende Schriftzüge.

In einer weiteren Ausführungsform weist zumindest eine an die erste Elektrodenschicht angrenzende Schicht des Schichtstapels des Substrats einen geringeren Brechungsindex als die anderen Schichten des Schichtstapels auf.

Hiermit wird erreicht, dass das von den Leuchtpunkten abgestrahlte Licht entweder gezielt durch die zugehörige Linse nach vorn abgestrahlt wird, oder aber an der niederbrechenden Schicht totalreflektiert wird. Damit wird eine bessere Definition des Abstrahlprofils erreicht und "Übersprechen" bzw. "Nebenmaxima" werden vermieden. Möglicherweise kann damit auch die Intensität der Abstrahlung in die gewünschte Richtung gesteigert werden.

Vorteilhaft können alle Ausführungsformen des hierin beschriebenen erfindungsgemäßen Verfahrens in Kombination mit einer oder mehreren der hierin genannten und beschriebenen Ausführungsformen realisiert werden.

Weitere Ausführungsformen, sowie einige der Vorteile, die mit diesen und weiteren Ausführungsformen verbunden sind, werden durch die nachfolgende ausführliche Beschreibung unter Bezug auf die begleitenden Figuren detaillierter und besser verständlich. Die Figuren sind lediglich schematische Darstellungen einer Ausführungsform der Erfindung.

## Figurenbeschreibung

Dabei zeigen

Fig. 1     ein schematisches Blockdiagramm gemäß einer Ausführungsform des erfindungsgemäßen Verfahrens,

Fig. 2     ein schematisches Blockdiagramm eines nicht erfindungsgemäßen Verfahrens,

Fig. 3     ein schematisches Blockdiagramm eines nicht erfindungsgemäßen Verfahrens,

Fig. 4     eine schematische Querschnittsansicht eines nicht erfindungsgemäßen Beispiels,

Fig. 5     eine schematische Querschnittsansicht einer Ausführungsform, welche gemäß dem erfindungsgemäßen Verfahren hergestellt werden kann,

Fig. 6     eine schematische Querschnittsansicht eines nicht erfindungsgemäßen Beispiels.

## Detaillierte Beschreibung

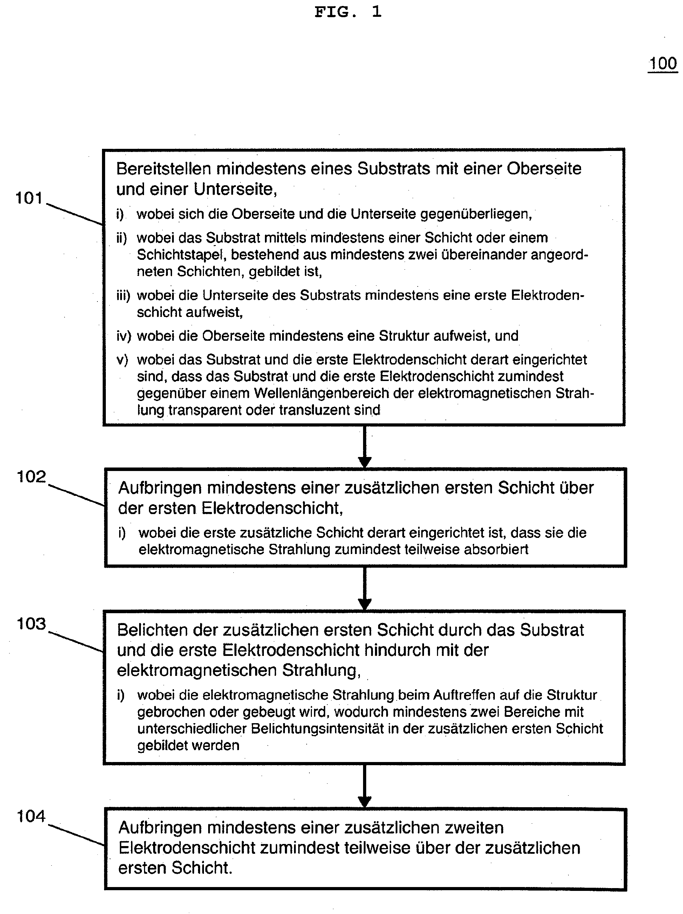

In Fig. 1 wird eine Ausführungsform des erfindungsgemäßen Verfahrens zum Herstellen mindestens eines optoelektronischen aktiven Bauteils mittels Belichtens mit elektromagnetischer Strahlung schematisch dargestellt 100. Das Verfahren 100 weist dabei auf: Bereitstellen mindestens eines Substrats mit einer Oberseite und einer Unterseite, wobei sich die Oberseite und die Unterseite gegenüberliegen, wobei das Substrat mittels mindestens einer Schicht oder einem Schichtstapel, bestehend aus mindestens zwei übereinander angeordneten Schichten, gebildet ist, wobei die Unterseite des Substrats mindestens eine erste Elektrodenschicht aufweist, wobei die Oberseite mindestens eine Struktur aufweist, und wobei das Substrat und die erste Elektrodenschicht derart eingerichtet sind, dass das Substrat und die erste Elektrodenschicht zumindest gegenüber einem Wellenlängenbereich der elektromagnetischen Strahlung transparent oder transluzent sind 101.

Mit dem Begriff Elektrodenschicht werden hierbei eine Schicht oder mehrere Schichten bezeichnet, die in transversaler und/oder zum Schichtsystem senkrechter Richtung eine elektrische Leitfähigkeit aufweisen.

Die Ober- und Unterseite des Substrats werden mittels der Flächen des Substrats gebildet, welche die größte räumliche Ausdehnung aufweisen.

Das Substrat wird entweder aus einer Schicht gebildet oder das Substrat wird mittels eines Schichtaufbaus gebildet, aufweisend eine Schicht oder mehrere Schichten, wobei die Schichten jeweils mittels eines Materials oder mehrerer Materialien gebildet sind. Für den Fall, dass das Substrat aus mehreren Schichten bzw. Materialien gebildet ist, sind die Schichten gemäß einem Schichtstapel gebildet.

Das bereitgestellte Substrat wird beispielsweise mittels mindestens eines Materials aus der Gruppe von Substratmaterialien gebildet werden, wobei die Gruppe von Substratmaterialien aufweist:

Dünnglas, Polyethylen, Polypropylen, Polyvinylchlorid, Polystyrol, Polycarbonat, Cellophan, Polylactid, Celluloseacetat, Polyimid, Polyamid, Polyethylenterephthalat, Polyethylennaphthalat, Polymethymetharcrylat, Polyetheretherketon, Keramikfolie.

Die bereitgestellte mindestens eine erste Elektrodenschicht über der Unterseite des Substrats wird beispielsweise mittels mindestens eines Materials aus der Gruppe von Elektrodenschichtmaterialien gebildet, wobei die Gruppe von Elektrodenschichtmaterialien aufweist:

Kupfer, Silber, Gold, Aluminium, Poly-3,4-ethylendiosythiophen-Polystyrolsulfonat (PEDOT:PSS), Poly-3,4-ethylendiosythiophen-Toluolsulfonsäure (PEDOT:Tos), Indium dotiertes Zinnoxid (ITO), Aluminiumdotiertes Zinkoxid (AZO), Indium dotiertes Zinkoxid (IZO), Wolframoxid (WO$_3$)

Die Struktur auf der Oberseite des Substrats weist mindestens eine Struktur auf, die derart eingerichtet ist, dass die Struktur eingestrahltes Licht an deren Oberfläche bricht oder beugt. Die Beugung oder Brechung an der Oberfläche der Struktur bewirkt, dass das eingestrahlte Licht mit mindestens zwei unterschiedlichen Belichtungsintensitäten zumindest teilweise in den darunterliegenden Schichten ankommt, was in den Bereichen zu einem unterschiedlichen Energieeintrag führt. Die unterschiedlichen mindestens zwei Belichtungsintensitätsbereiche werden dabei direkt in Abhängigkeit von der Struktur auf der Oberseite des Substrats generiert. Beispielsweise ist die Struktur auf der Oberseite des Substrats derart gebildet, dass sie wie eine Optik bzw. Linse wirkt, z.B. fokussierend.

Das bereitgestellte mindestens eine Substrat und die mindestens eine erste Elektrodenschicht sind derart eingerichtet, dass das Substrat und die erste Elektrodenschicht zumindest gegenüber einem zuvor bestimmten Wellenlängenbereich der elektromagnetischen Strahlung transparent oder transluzent sind, d.h. sie sind transmissiv bzw. durchlässig gegenüber der eingestrahlten elektromagnetischen Strahlung oder absorbieren bzw. reflektieren auch wiederum einen Teil der eingestrahlten elektromagnetischen Strahlung und lassen den anderen Teil durch. Mit anderen Worten können das Substrat und die Elektrodenschicht entweder die eingestrahlte elektromagnetische Strahlung vollständig durchlassen oder wie ein Filter für einen Teil der eingestrahlten elektromagnetischen Strahlung wirken und diesen absorbieren bzw. reflektieren, wohingegen der nicht gefilterte Anteil der eingestrahlten elektromagnetischen Strahlung dann durchgelassen wird.

Aufbringen mindestens einer zusätzlichen ersten Schicht über der ersten Elektrodenschicht, wobei die erste zusätzliche Schicht derart eingerichtet ist, dass sie die elektromagnetische Strahlung zumindest teilweise absorbiert 102.

Die mindestens eine zusätzliche erste Schicht über der mindestens einen ersten Elektrodenschicht wird beispielsweise mittels mindestens eines Aufbringverfahrens aus der Gruppe von Aufbringverfahren über der mindestens einen ersten Elektrodenschicht aufgebracht, wobei die Gruppe von Aufbringverfahren aufweist: Ein Druckverfahren, wie zum Beispiel ein Siebdruckverfahren,

ein Tiefdruckverfahren, ein Flexodruckverfahren,

ein Offsetdruckverfahren, ein Schlitzgießverfahren,

ein Vorhangbeschichtungsverfahren, ein Rakelverfahren,

ein Sprühverfahren, ein Bedampfungsverfahren,

ein Sputterverfahren, ein Gasphasenabscheidungsverfahren, ein Tauchbeschichtungsverfahren,

ein Walzenbeschichtungsverfahren,

ein Galvanisierungsverfahren,

ein Pulverbeschichtungsverfahren.

Die mindestens eine zusätzliche erste Schicht über der mindestens einen ersten Elektrodenschicht wird beispielsweise mittels mindestens eines Materials aus der Gruppe von Schichtmaterialien gebildet werden, wobei die Gruppe von Schichtmaterialien aufweist: Materialien, deren elektrische Leitfähigkeit in deren Volumen und/oder am Übergang zu mindestens einer angrenzenden Schicht geändert werden kann, wie z.B. photonisch aktivierbare Elektrodenschichten.

Jedoch können auch mehr als die mindestens eine zusätzliche erste Schicht über der mindestens einen ersten Elektrodenschicht aufgebracht werden, wobei die zusätzlich aufgebrachten Schichten wiederum als Schichtstapel über der mindestens einen ersten Elektrodenschicht aufgebracht sein können. Darüber hinaus können die zusätzlich aufgebrachten Schichten jeweils aus dem gleichen Material wie die mindestens eine zusätzliche Schicht oder aus unterschiedlichen Materialien gebildet sein, wobei die Materialien dabei den elektrischen Stromfluss durch die Schicht in angrenzende Schichten hindurch und/oder in Richtung der Schichtfläche ermöglichen.

Belichten der zusätzlichen ersten Schicht durch das Substrat und die erste Elektrodenschicht hindurch mit der elektromagnetischen Strahlung, wobei die elektromagnetische Strahlung beim Auftreffen auf die Struktur gebrochen oder gebeugt wird, wodurch mindestens zwei Bereiche mit unterschiedlicher Belichtungsintensität in der zusätzlichen ersten Schicht gebildet werden 103.

Die zum Belichten eingesetzte elektromagnetische Strahlung umfasst einen zuvor bestimmten Wellenlängenbereich des elektromagnetischen Spektrums, wobei der Wellenlängenbereich im Infrarot-, im sichtbaren und/oder im ultravioletten Spektralbereich liegen kann.

Die Belichtungsstärke bzw. -intensität und die Dauer der Belichtung wird an die zu belichtende Schicht oder die zu belichtenden Schichten jeweils angepasst, wobei auch der Einfluss des Substrats und der mindestens eine ersten Elektrodenschicht dabei berücksichtigt wird, sowie der Einfluss der Struktur auf der Oberfläche des Substrats.

Aufbringen mindestens einer zusätzlichen zweiten Elektrodenschicht zumindest teilweise über der zusätzlichen ersten Schicht 104.

Mit dem Begriff Elektrodenschicht werden hierbei eine Schicht oder mehrere Schichten bezeichnet, die in transversaler und/oder zum Schichtsystem senkrechter Richtung eine elektrische Leitfähigkeit aufweisen.

Die mindestens eine zusätzliche zweite Elektrodenschicht zumindest teilweise über der zusätzlichen ersten Schicht wird beispielsweise mittels mindestens eines Aufbringverfahrens aus der Gruppe von Aufbringverfahren zumindest teilweise über der zusätzlichen ersten Schicht aufgebracht, wobei die Gruppe von Aufbringverfahren aufweist:

Ein Druckverfahren, wie zum Beispiel ein Siebdruckverfahren,
ein Tiefdruckverfahren, ein Flexodruckverfahren,
ein Offsetdruckverfahren, ein Schlitzgießverfahren,
ein Vorhangbeschichtungsverfahren, ein Rakelverfahren,
ein Sprühverfahren, ein Bedampfungsverfahren,
ein Sputterverfahren, ein Gasphasenabscheidungsverfahren,

ein Tauchbeschichtungsverfahren,
ein Walzenbeschichtungsverfahren,
ein Galvanisierungsverfahren,
ein Pulverbeschichtungsverfahren.

Die mindestens eine zusätzliche zweite Elektrodenschicht zumindest teilweise über der zusätzlichen ersten Schicht wird beispielsweise mittels mindestens eines Materials aus der Gruppe von Elektrodenschichtmaterialien gebildet, wobei die Gruppe von Elektrodenschichtmaterialien aufweist:
Kupfer, Silber, Gold, Aluminium, Poly-3,4-ethylendiosythiophen-Polystyrolsulfonat (PEDOT:PSS), Poly-3,4-ethylendiosythiophen-Toluolsulfonsäure (PEDOT:Tos), Indium dotiertes Zinnoxid (ITO), Aluminiumdotiertes Zinkoxid (AZO), Indium dotiertes Zinkoxid (IZO), Wolframoxid ($WO_3$).

Jedoch können auch mehr als mindestens eine zusätzliche zweite Elektrodenschicht zumindest teilweise über der zusätzlichen ersten Schicht aufgebracht werden, wobei in diesem Fall die zusätzlichen Elektrodenschichten wiederum als Schichtstapel über der zusätzlichen ersten Schicht aufgebracht sein können. Darüber hinaus können die zusätzlich aufgebrachten Schichten jeweils aus dem gleichen Material wie die mindestens eine zusätzliche Schicht oder aus unterschiedlichen Materialien gebildet sein, wobei die Materialien dabei den elektrischen Stromfluss durch die Schicht in angrenzende Schichten hindurch und/oder in Richtung der Schichtfläche ermöglichen.

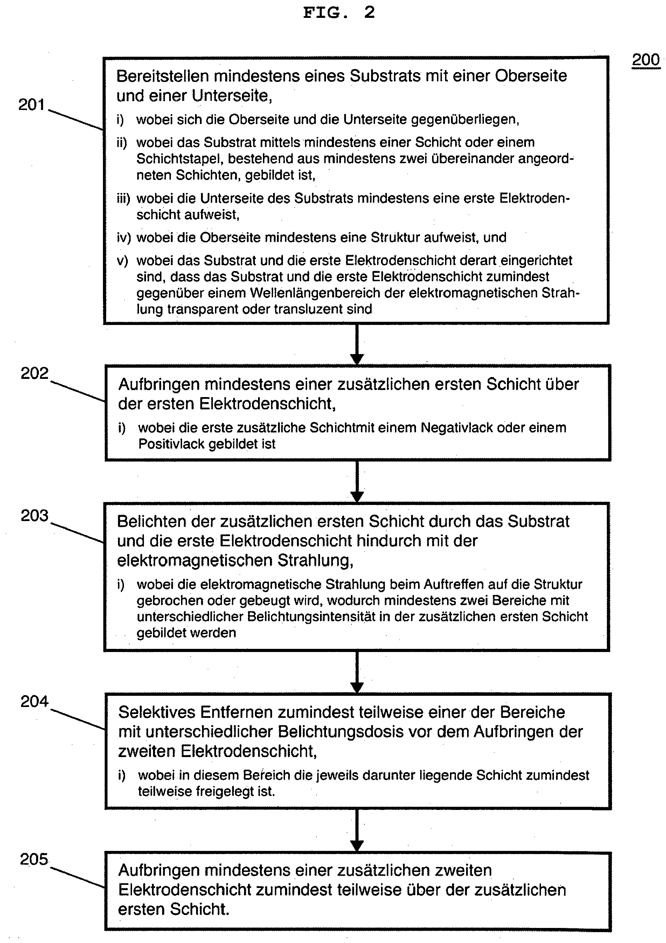

In Fig. 2 wird ein nicht erfindungsgemäßes Beispiel eines Verfahrens zum Herstellen mindestens eines optoelektronischen aktiven Bauteils mittels Belichtens mit elektromagnetischer Strahlung schematisch dargestellt 200. Das Verfahren 200 weist dabei auf:
Bereitstellen mindestens eines Substrats mit einer Oberseite und einer Unterseite, wobei sich die Oberseite und die Unterseite gegenüberliegen, wobei das Substrat mittels mindestens einer Schicht oder einem Schichtstapel, bestehend aus mindestens zwei übereinander angeordneten Schichten, gebildet ist, wobei die Unterseite des Substrats mindestens eine erste Elektrodenschicht aufweist, wobei die Oberseite mindestens eine Struktur aufweist, und wobei das Substrat und die erste Elektrodenschicht derart eingerichtet sind, dass das Substrat und die erste Elektrodenschicht zumindest gegenüber einem Wellenlängenbereich der elektromagnetischen Strahlung transparent oder transluzent sind 201.

Mit dem Begriff Elektrodenschicht werden hierbei eine Schicht oder mehrere Schichten bezeichnet, die in transversaler und/oder zum Schichtsystem senkrechter Richtung eine elektrische Leitfähigkeit aufweisen.

Die Ober- und Unterseite des Substrats werden mittels der Flächen des Substrats gebildet, welche die größte räumliche Ausdehnung aufweisen.

Das Substrat wird entweder aus einer Schicht gebildet oder das Substrat wird mittels eines Schichtaufbaus, aufweisend eine Schicht oder mehrere Schichten, gebildet, wobei die Schichten jeweils mittels eines Materials oder mehrerer Materialien gebildet sind. Für den Fall, dass das Substrat aus mehreren Schichten bzw. Materialien gebildet ist, können die Schichten gemäß einem Schichtstapel gebildet sein.

Das bereitgestellte Substrat wird beispielsweise mittels mindestens eines Materials aus der Gruppe von Substratmaterialien gebildet, wobei die Gruppe von Substratmaterialien aufweist:

Dünnglas, Polyethylen, Polypropylen, Polyvinylchlorid, Polystyrol, Polycarbonat, Cellophan, Polylactid, Celluloseacetat, Polyimid, Polyamid, Polyethylenterephthalat, Polyethylennaphthalat, Polymethymetharcrylat, Polyetheretherketon, Keramikfolie.

Die bereitgestellte mindestens eine erste Elektrodenschicht über der Unterseite des Substrats wird beispielsweise mittels mindestens eines Materials aus der Gruppe von Elektrodenschichtmaterialien gebildet, wobei die Gruppe von Elektrodenschichtmaterialien aufweist:

Kupfer, Silber, Gold, Aluminium, Poly-3,4-ethylendiosythiophen-Polystyrolsulfonat (PEDOT:PSS), Poly-3,4-ethylendiosythiophen-Toluolsulfonsäure(PEDOT:Tos), Indium dotiertes Zinnoxid (ITO), Aluminiumdotiertes Zinkoxid (AZO), Indium dotiertes Zinkoxid (IZO), Wolframoxid ($WO_3$).

Die Struktur auf der Oberseite des Substrats weist mindestens eine Struktur auf, die derart eingerichtet ist, dass die Struktur eingestrahltes Licht an deren Oberfläche bricht oder beugt. Die Beugung oder Brechung an der Oberfläche der Struktur bewirkt, dass das eingestrahlte Licht mit mindestens zwei unterschiedlichen Belichtungsintensitäten zumindest teilweise in den darunterliegenden Schichten ankommt, was in den Bereichen zu einem unterschiedlichen Energieeintrag führt. Die unterschiedlichen mindestens zwei Belichtungsintensitätsbereiche werden dabei direkt in Abhängigkeit von der Struktur auf der Oberseite des Substrats generiert. Beispielsweise ist die Struktur auf der Oberseite des Substrats derart gebildet, dass sie wie eine Optik bzw. Linse wirkt, z.B. fokussierend.

Das bereitgestellte mindestens eine Substrat und die mindestens eine erste Elektrodenschicht sind derart eingerichtet, dass das Substrat und die erste Elektrodenschicht zumindest gegenüber einem zuvor bestimmten Wellenlängenbereich der elektromagnetischen Strahlung transparent oder transluzent sind, d.h. sie können transmissiv bzw. durchlässig gegenüber der eingestrahlten elektromagnetischen Strahlung sein oder auch wiederum einen Teil der eingestrahlten elektromagnetischen Strahlung absorbieren bzw. reflektieren und den anderen Teil durchlassen. Mit anderen Worten können Substrat und die Elektrodenschicht entweder die eingestrahlte elektromagnetische Strahlung vollständig durchlassen oder wie ein Filter für einen Teil der eingestrahlten elektromagnetischen Strahlung wirken und diesen absorbieren bzw. reflektieren, wohingegen der nicht gefilterte Anteil der eingestrahlten elektromagnetischen Strahlung dann durchgelassen wird.

Aufbringen mindestens einer zusätzlichen ersten Schicht über der ersten Elektrodenschicht, wobei die erste zusätzliche Schicht derart eingerichtet ist, dass sie die elektromagnetische Strahlung zumindest teilweise absorbiert 202.

Die mindestens eine zusätzliche erste Schicht über der mindestens einen ersten Elektrodenschicht wird beispielsweise mittels mindestens eines Aufbringverfahrens aus.der Gruppe von Aufbringverfahren über der mindestens einen ersten Elektrodenschicht aufgebracht, wobei die Gruppe von Aufbringverfahren aufweist:

Ein Druckverfahren, wie zum Beispiel ein Siebdruckverfahren,
ein Tiefdruckverfahren, ein Flexodruckverfahren, ein Offsetdruckverfahren, ein Schlitzgießverfahren, ein Vorhangbeschichtungsverfahren, ein Rakelverfahren,
ein Sprühverfahren, ein Bedampfungsverfahren, ein Sputterverfahren, ein Gasphasenabscheidungsverfahren,
ein Tauchbeschichtüngsverfahren,
ein Walzenbeschichtungsverfahren,
ein Galvanisierungsverfahren,
ein Pulverbeschichtungsverfahren.

Die mindestens eine zusätzliche erste Schicht über der mindestens einen ersten Elektrodenschicht wird beispielsweise mittels mindestens eines Materials aus der Gruppe von Schichtmaterialien gebildet, wobei die Gruppe von photoaktiven Schichtmaterialien aufweist: Positiv-Photolacke, Negativ-Photolacke, Umkehr-Photolacke, photovernetzbare Polymere, photoaktivierbare Säuren, photozersetzbare Löslichkeitsinhibitoren.

Jedoch können auch mehr als die mindestens eine zusätzliche erste Schicht über der mindestens einen ersten Elektrodenschicht aufgebracht werden, wobei die zusätzlich aufgebrachten Schichten wiederum als Schichtstapel über der mindestens einen ersten Elektrodenschicht aufgebracht sein können. Darüber hinaus können die zusätzlich aufgebrachten Schichten jeweils aus dem gleichen Material wie die mindestens eine zusätzliche Schicht oder aus unterschiedlichen Materialien gebildet sein, wobei die Materialien dabei den elektrischen Stromfluss durch die Schicht in angrenzende Schichten hindurch und/oder in Richtung der Schichtfläche ermöglichen.

Belichten der zusätzlichen ersten Schicht durch das Substrat und die erste Elektrodenschicht hindurch mit der elektromagnetischen Strahlung, wobei die elektromagnetische Strahlung beim Auftreffen auf die Struktur gebrochen oder gebeugt wird, wodurch mindestens zwei Bereiche mit unterschiedlicher Belichtungsintensität in der zusätzlichen ersten Schicht gebildet werden 203.

Die zum Belichten eingesetzte elektromagnetische Strahlung umfasst einen zuvor bestimmten Wellenlängenbereich des elektromagnetischen Spektrums, wobei der Wellenlängenbereich im Infrarot-, im sichtbaren und/oder im ultravioletten Spektralbereich liegt.

Die Belichtungsstärke bzw. -intensität und die Dauer der Belichtung wird an die zu belichtende Schicht oder die zu belichtenden Schichten jeweils angepasst, wobei auch der Einfluss des Substrats und der mindestens eine ersten Elektrodenschicht dabei berücksichtigt wird, sowie der Einfluss der Struktur auf der Oberfläche des Substrats.

Selektives Entfernen zumindest teilweise einer der Bereiche mit unterschiedlicher Belichtungsdosis vor dem Aufbringen der mindestens einen zweiten Elektrodenschicht, wobei in diesem Bereich die jeweils darunter liegende Schicht zumindest teilweise freigelegt wird 204.

Das selektive Entfernen zumindest teilweise einer der Bereiche mit unterschiedlicher Belichtungsdosis vor dem Aufbringen der mindestens einen zweiten Elektrodenschicht, wobei in diesem Bereich die jeweils darunter liegende Schicht zumindest teilweise freigelegt wird, wird beispielsweise mittels mindestens eines selektiven Entfernverfahren aus der Gruppe von selektiven Entfernverfahren zumindest teilweise entfernt werden, wobei die Gruppe von selektiven Entfernverfahren aufweist: Das selektive Lösen in einem Lösemittel, eine selektive chemische Reaktion mit einem flüssigen, festen oder gasförmigen Ätzmittel, eine thermisch induzierte chemische Zersetzung, eine katalytisch induzierte chemische Zersetzung, Schmelzen, Verdampfen, mechanische Entfernung.

Aufbringen mindestens einer zusätzlichen zweiten Elektrodenschicht zumindest teilweise über der zusätzlichen ersten Schicht 205.

Mit dem Begriff Elektrodenschicht werden hierbei eine Schicht oder mehrere Schichten bezeichnet, die in transversaler und/oder zum Schichtsystem senkrechter Richtung eine elektrische Leitfähigkeit aufweisen.

Die mindestens eine zusätzliche zweite Elektrodenschicht zumindest teilweise über der zusätzlichen ersten Schicht wird beispielsweise mittels mindestens eines Aufbringverfahrens aus der Gruppe von Aufbringverfahren zumindest teilweise über der zusätzlichen ersten Schicht aufgebracht, wobei die Gruppe von Aufbringverfahren aufweist: Ein Druckverfahren, wie zum Beispiel ein Siebdruckverfahren, ein Tiefdruckverfahren, ein Flexodruckverfahren, ein Offsetdruckverfahren, ein Schlitzgießverfahren, ein Vorhangbeschichtungsverfahren, ein Rakelverfahren, ein Sprühverfahren, ein Bedampfungsverfahren, ein Sputterverfahren, ein Gasphasenabscheidungsverfahren, ein Tauchbeschichtungsverfahren, ein Walzenbeschichtungsverfahren, ein Galvanisierungsverfahren, ein Pulverbeschichtungsverfahren.

Die mindestens eine zusätzliche zweite Elektrodenschicht zumindest teilweise über der zusätzlichen ersten Schicht wird beispielsweise mittels mindestens eines Materials aus der Gruppe von Elektrodenschichtmaterialien gebildet, wobei die Gruppe von Elektrodenschichtmaterialien aufweist: Kupfer, Silber, Gold, Aluminium, Poly-3,4-ethylendiosythiophen-Polystyrolsulfonat (PEDOT:PSS), Poly-3,4-ethylendiosythiophen-Toluolsulfonsäure (PEDOT:Tos), Indium dotiertes Zinnoxid (ITO), Aluminiumdotiertes Zinkoxid (AZO), Indium dotiertes Zinkoxid (IZO), Wolframoxid (WO$_3$).

Jedoch können auch mehr als mindestens eine zusätzliche zweite Elektrodenschicht zumindest teilweise über der zusätzlichen ersten Schicht aufgebracht werden, wobei in diesem Fall die zusätzlichen Elektrodenschichten wiederum als Schichtstapel über der zusätzlichen ersten Schicht aufgebracht sein können. Darüber hinaus können die zusätzlich aufgebrachten Schichten jeweils aus dem gleichen Material wie die mindestens eine zusätzliche Schicht oder aus unterschiedlichen Materialien gebildet sein, wobei die Materialien dabei den elektrischen Stromfluss durch die Schicht in angrenzende Schichten hindurch und/oder in Richtung der Schichtfläche ermöglichen.

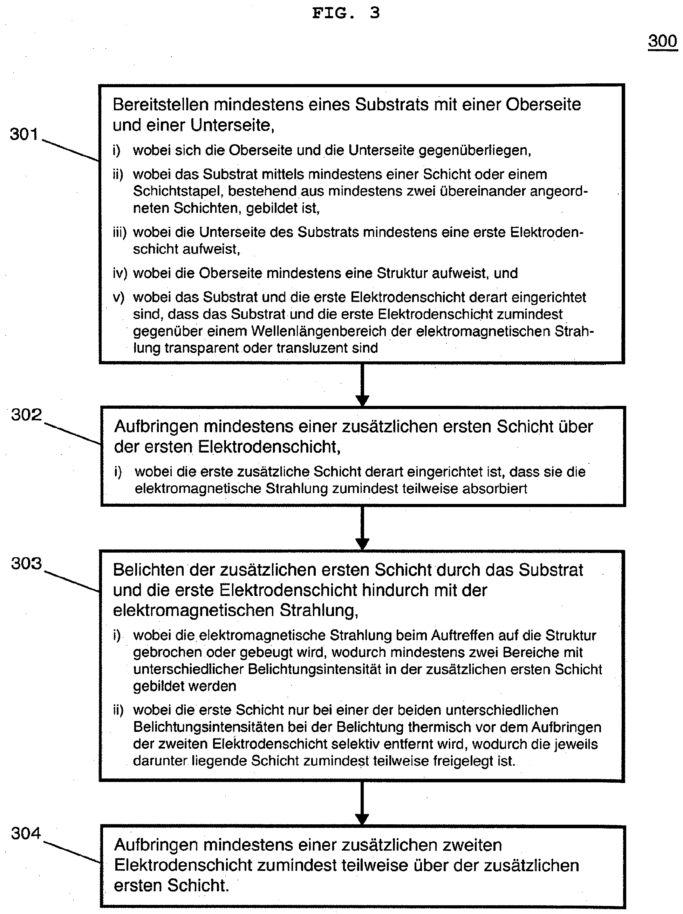

In Fig. 3 wird ein nicht erfindungsgemäßes Beispiel eines Verfahrens zum Herstellen mindestens eines optoelektronischen aktiven Bauteils mittels Belichtens mit elektromagnetischer Strahlung schematisch dargestellt 300. Das Verfahren 300 weist dabei auf: Bereitstellen mindestens eines Substrats mit einer Oberseite und einer Unterseite, wobei sich die Oberseite und die Unterseite gegenüberliegen, wobei das Substrat mittels mindestens einer Schicht oder einem Schichtstapel, bestehend aus mindestens zwei übereinander angeordneten Schichten, gebildet ist, wobei die Unterseite des Substrats mindestens eine erste Elektrodenschicht aufweist, wobei die Oberseite mindestens eine Struktur aufweist, und wobei das Substrat und die erste Elektrodenschicht derart eingerichtet sind, dass das Substrat und die erste Elektrodenschicht zumindest gegenüber einem Wellenlängenbereich der elektromagnetischen Strahlung transparent oder transluzent sind 301.

Mit dem Begriff Elektrodenschicht werden hierbei eine Schicht oder mehrere Schichten bezeichnet, die in transversaler und/oder zum Schichtsystem senkrechter Richtung eine elektrische Leitfähigkeit aufweisen.

Die Ober- und Unterseite des Substrats werden mittels der Flächen des Substrats gebildet, welche die größte räumliche Ausdehnung aufweisen.

Das Substrat wird entweder aus einer Schicht gebildet oder das Substrat kann mittels eines Schichtaufbaus, aufweisend eine Schicht oder mehrere Schichten, gebildet werden, wobei die Schichten jeweils mittels eines Materials oder mehrerer Materialien gebildet sind. Für den Fall, dass das Substrat aus mehreren Schichten bzw. Materialien gebildet ist, sind die Schichten gemäß einem Schichtstapel gebildet.

Das bereitgestellte Substrat wird beispielsweise mittels mindestens eines Materials aus der Gruppe von Substratmaterialien gebildet, wobei die Gruppe von Substratmaterialien aufweist:
Dünnglas, Polyethylen, Polypropylen, Polyvinylchlorid, Polystyrol, Polycarbonat, Cellophan, Polylactid, Celluloseacetat, Polyimid, Polyamid, Polyethylenterephthalat, Polyethylennaphthalat, Polymethymetharcrylat, Polyetheretherketon, Keramikfolie.

Die bereitgestellte mindestens eine erste Elektrodenschicht über der Unterseite des Substrats wird beispielsweise mittels mindestens eines Materials aus der Gruppe von Elektrodenschichtmaterialien gebildet, wobei die Gruppe von Elektrodenschichtmaterialien aufweist:

Kupfer, Silber, Gold, Aluminium, Poly-3,4-ethylendiosythiophen-Polystyrolsulfonat (PEDOT:PSS), Poly-3,4-ethylendiosythiophen-Toluolsulfonsäure(PEDOT:Tos), Indium dotiertes Zinnoxid (ITO), Aluminiumdotiertes Zinkoxid (AZO), Indium dotiertes Zinkoxid (IZO), Wolframoxid ($WO_3$).

Die Struktur auf der Oberseite des Substrats weist mindestens eine Struktur auf, die derart eingerichtet ist, dass die Struktur eingestrahltes Licht an deren Oberfläche bricht oder beugt. Die Beugung oder Brechung an der Oberfläche der Struktur bewirkt, dass das eingestrahlte Licht mit mindestens zwei unterschiedlichen Belichtungsintensitäten zumindest teilweise in den darunterliegenden Schichten ankommt, was in den Bereichen zu einem unterschiedlichen Energieeintrag führt. Die unterschiedlichen mindestens zwei Belichtungsintensitätsbereiche werden dabei direkt in Abhängigkeit von der Struktur auf der Oberseite des Substrats generiert. Beispielsweise ist die Struktur auf der Oberseite des Substrats derart gebildet, dass sie wie eine Optik bzw. Linse wirkt, z.B. fokussierend.

Das bereitgestellte mindestens eine Substrat und die mindestens eine erste Elektrodenschicht sind derart eingerichtet, dass das Substrat und die erste Elektrodenschicht zumindest gegenüber einem zuvor bestimmten Wellenlängenbereich der elektromagnetischen Strahlung transparent oder transluzent sind, d.h. sie können transmissiv bzw. durchlässig gegenüber der eingestrahlten elektromagnetischen Strahlung sein oder auch wiederum einen Teil der eingestrahlten elektromagnetischen Strahlung absorbieren bzw. reflektieren und den anderen Teil durchlassen. Mit anderen Worten können das Substrat und die Elektrodenschicht entweder die eingestrahlte elektromagnetische Strahlung vollständig durchlassen oder wie ein Filter für einen Teil der eingestrahlten elektromagnetischen Strahlung wirken und diesen absorbieren bzw. reflektieren, wohingegen der nicht gefilterte Anteil der eingestrahlten elektromagnetischen Strahlung dann durchgelassen wird.

Aufbringen mindestens einer zusätzlichen ersten Schicht über der ersten Elektrodenschicht, wobei die erste zusätzliche Schicht derart eingerichtet ist, dass sie die elektromagnetische Strahlung zumindest teilweise absorbiert 302.

Die mindestens eine zusätzliche erste Schicht über der mindestens einen ersten Elektrodenschicht wird beispielsweise mittels mindestens eines Aufbringverfahrens aus der Gruppe von Aufbringverfahren über der mindestens einen ersten Elektrodenschicht aufgebracht, wobei die Gruppe von Aufbringverfahren aufweist:

Ein Druckverfahren, wie zum Beispiel ein Siebdruckverfahren,
ein Tiefdruckverfahren, ein Flexodruckverfahren,
ein Offsetdruckverfahren, ein Schlitzgießverfahren,
ein Vorhangbeschichtungsverfahren, ein Rakelverfahren,
ein Sprühverfahren, ein Bedampfungsverfahren,
ein Sputterverfahren, ein Gasphasenabscheidungsverfahren,
ein Tauchbeschichtungsverfahren,
ein Walzenbeschichtungsverfahren,
ein Galvanisierungsverfahren,
ein Pulverbeschichtungsverfahren.

Die mindestens eine zusätzliche erste Schicht über der mindestens einen ersten Elektrodenschicht wird beispielsweise mittels mindestens eines Materials aus der Gruppe von Schichtmaterialien gebildet, wobei die Gruppe von Schichtmaterialien thermisch oder photonisch ablatierbare Isolatormaterialien aufweist.

Jedoch können auch mehr als die mindestens eine zusätzliche erste Schicht über der mindestens einen ersten Elektrodenschicht aufgebracht werden, wobei die zusätzlich aufgebrachten Schichten wiederum als Schichtstapel über der mindestens einen ersten Elektrodenschicht aufgebracht sein können. Darüber hinaus können die zusätzlich aufgebrachten Schichten jeweils aus dem gleichen Material wie die mindestens eine zusätzliche Schicht oder aus unterschiedlichen Materialien gebildet sein, wobei die Materialien dabei den elektrischen Stromfluss durch die Schicht in angrenzende Schichten hindurch und/oder in Richtung der Schichtfläche ermöglichen.

Belichten der zusätzlichen ersten Schicht durch das Substrat und die erste Elektrodenschicht hindurch mit der elektromagnetischen Strahlung, wobei die elektromagnetische Strahlung beim Auftreffen auf die Struktur gebrochen oder gebeugt wird, wodurch mindestens zwei Bereiche mit unterschiedlicher Belichtungsintensität in der zusätzlichen ersten Schicht gebildet werden, und wobei die mindestens eine erste zusätzliche Schicht nur bei einer der mindestens zwei unterschiedlichen Belichtungsintensitäten bei der Belichtung thermisch vor dem Aufbringen der mindestens einen zweiten Elektrodenschicht selektiv entfernt wird, wodurch die jeweils darunter liegende Schicht zumindest teilweise freigelegt wird 303.

Die zum Belichten eingesetzte elektromagnetische Strahlung umfasst einen zuvor bestimmten Wellenlängenbereich des elektromagnetischen Spektrums, wobei der Wellenlängenbereich im Infrarot-, im sichtbaren und/oder im ultravioletten Spektralbereich liegen kann.

Die Belichtungsstärke bzw. -intensität und die Dauer der Belichtung wird an die zu belichtende Schicht oder die zu belichtenden Schichten jeweils angepasst, wobei auch der Einfluss des Substrats und der mindestens eine ersten Elektrodenschicht dabei berücksichtigt wird, sowie der Einfluss der Struktur auf der Oberfläche des Substrats.

Das thermische selektive Entfernen wirkt hierbei ablativ, d.h. der zu entfernende Bereich oder die zu entfernenden Bereiche werden aufgrund des Energieeintrags in die Schicht thermisch von der darunterliegenden Schicht entfernt.

Aufbringen mindestens einer zusätzlichen zweiten Elektrodenschicht zumindest teilweise über der zusätzlichen ersten Schicht 304.

Mit dem Begriff Elektrodenschicht werden hierbei eine Schicht oder mehrere Schichten bezeichnet, die in transversaler und/oder zum Schichtsystem senkrechter Richtung eine elektrische Leitfähigkeit aufweisen.

Die mindestens eine zusätzliche zweite Elektrodenschicht zumindest teilweise über der zusätzlichen ersten Schicht wird beispielsweise mittels mindestens eines Aufbringverfahrens aus der Gruppe von Aufbringverfahren zumindest teilweise über der zusätzlichen ersten Schicht aufgebracht, wobei die Gruppe von Aufbringverfahren aufweist:

> Ein Druckverfahren, wie zum Beispiel ein Siebdruckverfahren,
> ein Tiefdruckverfahren, ein Flexodruckverfahren,
> ein Offsetdruckverfahren, ein Schlitzgießverfahren,
> ein Vorhangbeschichtungsverfahren, ein Rakelverfahren,
> ein Sprühverfahren, ein Bedampfungsverfahren,
> ein Sputterverfahren, ein Gasphasenabscheidungsverfahren,
> ein Tauchbeschichtungsverfahren,
> ein Walzenbeschichtungsverfahren,
> ein Galvanisierungsverfahren,
> ein Pulverbeschichtungsverfahren.

Die mindestens eine zusätzliche zweite Elektrodenschicht zumindest teilweise über der zusätzlichen ersten Schicht wird beispielsweise mittels mindestens eines Materials aus der Gruppe von Elektrodenschichtmaterialien gebildet, wobei die Gruppe von Elektrodenschichtmaterialien aufweist:
Kupfer, Silber, Gold, Aluminium, Poly-3,4-ethylendiosythiophen-Polystyrolsulfonat (PEDOT:PSS), Poly-3,4-ethylendiosythiophen-Toluolsulfonsäure(PEDOT:Tos), Indium dotiertes Zinnoxid (ITO), Aluminiumdotiertes Zinkoxid (AZO), Indium dotiertes Zinkoxid (IZO), Wolframoxid ($WO_3$).

Jedoch können auch mehr als mindestens eine zusätzliche zweite Elektrodenschicht zumindest teilweise über der zusätzlichen ersten Schicht aufgebracht werden, wobei in diesem Fall die zusätzlichen Elektrodenschichten wiederum als Schichtstapel über der zusätzlichen ersten Schicht aufgebracht sein können. Darüber hinaus können die zusätzlich aufgebrachten Schichten jeweils aus dem gleichen Material wie die mindestens eine zusätzliche Schicht oder aus unterschiedlichen Materialien gebildet sein, wobei die Materialien dabei den elektrischen Stromfluss durch die Schicht in angrenzende Schichten hindurch und/oder in Richtung der Schichtfläche ermöglichen.

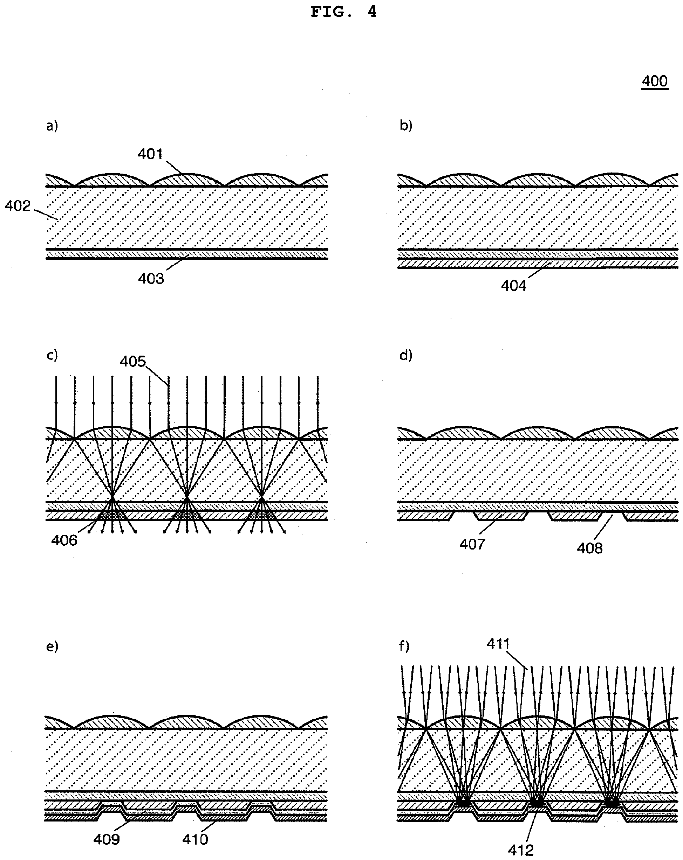

In Fig. 4 wird eine schematische Darstellung einer Querschnittsansicht einer exemplarischen Vorrichtung 400, welche nicht gemäß der Erfindung geformt wurde, gezeigt. Hierin werden einzelne Prozessschritte, dargestellt als Subfiguren a) bis f) des Verfahrens anhand von einzelnen Querschnitten der Vorrichtung zum Zeitpunkt des jeweiligen Prozessschrittes einer derart gebildeten Vorrichtung exemplarisch dargestellt.

In Subfigur a) ist ein gemäß mindestens einem der zuvor beschriebenen Verfahren (100, 200, 300) bereitgestelltes Substrat 402 dargestellt. Über dessen Oberfläche ist eine Struktur 401 gezeigt, wobei diese Struktur 401 beispielhaft eine Vielzahl von nach außen hin konvex geformte, d.h. ähnlich einer Fokussierlinse, Auswölbungen zeigt. Über der Unterseite ist eine erste Elektrodenschicht 403 dargestellt. Das Substrat 402 mit der Struktur 401 auf dessen Oberfläche und die Elektrodenschicht können gemäß mindestens einem der zuvor beschriebenen Verfahren 100, 200, 300 bereitgestellt sein, d.h. sie weisen die gleichen oder ähnliche Materialien bzw. elektronische und optische Eigenschaften auf.

In Subfigur b) ist eine zusätzliche Schicht 404 über der ersten Elektrodenschicht 403 aufgebracht, gemäß einem der zuvor beschriebenen erfindungsgemäßen Verfahren 100, 200, 300. Die eine zusätzliche Schicht 404 kann gemäß mindestens einem der zuvor beschriebenen Verfahren 100, 200, 300 aufgebracht sein bzw. weist sie die gleichen oder ähnliche Materialien bzw. elektronische und optische Eigenschaften auf.

In Subfigur c) ist die Belichtung der zusätzlichen Schicht 404 durch die Struktur 401, das Substrat 402 und die Elektrodenschicht 403 dargestellt gemäß mindestens einem der zuvor beschriebenen erfindungsgemäßen Verfahren 100, 200, 300. Dabei wird die elektromagnetische Strahlung 405 in dieser Ausführungsform parallel bzw. kollimiert eingestrahlt. Die Form der Struktur 401 ist derart eingerichtet, dass hierbei der Fokus der Lichtstrahlen innerhalb des Substrats 402 und nahe der ersten Elektrodenschicht 403 liegt. Dadurch wird jeweils ein Bereich der zusätzlichen Schicht 404 belichtet, wobei die Strahlung 406 unterhalb der zusätzlichen Schicht 404 wieder austritt. Die elektromagnetische

Belichtungsstrahlung 405, 406 ist gemäß mindestens einem der zuvor beschriebenen erfindungsgemäßen Verfahren 100, 200, 300 angepasst worden.

In Subfigur d) sind die selektiv entfernten Bereiche 408 bzw. die selektiv verbleibenden Bereich 407 gemäß mindestens einem der zuvor beschriebenen Verfahren 100, 200, 300 dargestellt. Das selektive Entfernen wurde gemäß mindestens einem der zuvor beschriebenen Verfahren 100, 200, 300 durchgeführt, d.h. es wurde mit gleichen oder ähnlichen Verfahren wie gemäß mindestens einem der zuvor beschriebenen Verfahren 100, 200, 300 selektiv entfernt.

In Subfigur e) ist dargestellt, wie exemplarische zusätzliche elektrische Funktionsschichten 409, 410 aufgebracht sind, die gemäß mindestens einem der zuvor beschriebenen erfindungsgemäßen Verfahren 100, 200, 300 aufgebracht worden sind, d.h. sie wurden mit gleichen oder ähnlichen Verfahren wie gemäß mindestens einem der zuvor beschriebenen erfindungsgemäßen Verfahren 100, 200, 300 aufgebracht und weisen gleich oder ähnliche elektronische bzw. elektrische und optische Eigenschaften auf. Darüber hinaus können sie aus gleichen oder ähnlichen Materialien gebildet sein, wie gemäß mindestens einem der zuvor beschriebenen erfindungsgemäßen Verfahren 100, 200, 300 offenbart.

In Subfigur f) ist das gemäß mindestens einem der zuvor beschriebenen Verfahren 100, 200, 300 optoelektronisch aktive Bauteil im operativen Betrieb dargestellt. Die zuvor freigelegten Bereich mit den darüber aufgebrachten zusätzlichen Schichten bilden dabei Lichtquellen 412, die Licht jeweils als Punktquelle durch das Substrat 402 und die darüber angeordnete Struktur 401 nach außen hin abstrahlen, wobei nunmehr die konvex geformte Struktur 401 ähnlich wie ein Kollimator auf das abgestrahlte Licht wirkt und dadurch eine nahezu flächige Lichtabstrahlung 411 für den Betrachter bereitstellt.

Mit anderen Worten, die eine Ausführungsform eines nicht erfindungsgemäßen Verfahrens ist in Fig. 4 in den Subfiguren a) bis f) dargestellt. Ausgangspunkt ist eine mit einem Mikrolinsenraster 401 bestückte Substratfolie 402. Auf deren Gegenseite befindet sich eine transparente Elektrodenschicht 403. Darauf wird ein Positiv-Fotolack 404 aufgebracht (siehe Figuren 4a und 4b).

Von der Linsen-Seite her wird dann bspw. paralleles bzw. kollimiertes UV-Licht 405 eingestrahlt. Bei geeigneter Substratfoliendicke bündelt sich das Licht auf der Gegenseite der Substratfolie im Fokus der Linsen, der im Inneren der Folie kurz oberhalb der Rückseite liegt (siehe Fig. 4c). Durch diese Fokussierung wird der Fotolack nur in einem begrenzten Bereich nahe dem Fokuspunkt mit ausreichend hoher Intensität belichtet 406. Nach der Entwicklung (das heißt Entfernung der belichteten Partien) ist also die Lackschicht derart strukturiert, dass eine Ausrichtung auf die Lage der Mikrolinsen automatisch gewährleistet ist (siehe Fig. 4d). Der auf den unbelichteten Flächen verbliebene Fotolack 407 erfüllt die Funktion eines elektrischen Isolators.

Im nächsten Prozessschritt werden die weiteren elektrischen Funktionsschichten der OLED 408, 409 aufgedampft (oder aus der Flüssigphase prozessiert). Bei Betrieb der so hergestellten OLED wird der Ladungstransport von der transparenten Elektrode zur Licht generierenden organischen Schicht überall dort vom Fotolack geblockt, wo dieser nicht belichtet worden war. Auf diese Weise wird also effektiv eine OLED hergestellt, die nur nahe dem Fokus der Mikrolinsen Licht erzeugt (siehe Fig. 2e).

Auf Grund der Umkehrbarkeit des Lichtweges wird das von den aktiven OLED Flächen 411 erzeugte Licht dann bevorzugt in die Richtung gestrahlt, aus welcher beim Belichtungsschritt das UV Licht eingefallen war (410 in Fig. 2f). In dieser Konfiguration wird außerdem die totale interne Reflexion im Akzeptanzbereich der Linsen an der Substrat/Luft Oberfläche unterdrückt, so dass eine erhöhte Lichtausbeute erreicht werden kann.

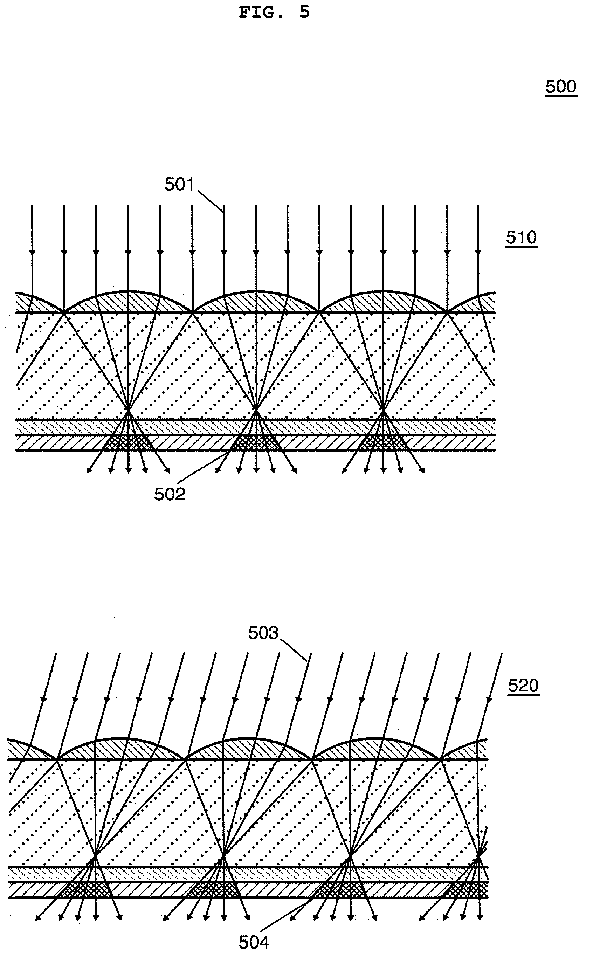

In Fig. 5 sind zwei exemplarische Querschnittsansichten von Ausführungsformen für die Belichtung 510, 520 gemäß mindestens einem der zuvor beschriebenen erfindungsgemäßen Verfahren 100, 200, 300 dargestellt.

Die Belichtung wie in 510 dargestellt, zeigt beispielhaft ein Belichten des optoelektronischen Bauteils mit kollimierter bzw. paralleler elektromagnetischer Strahlung 501 gemäß mindestens einem der zuvor beschriebenen erfindungsgemäßen Verfahren 100, 200, 300, so dass definierte Emissionsbereiche 502 generiert werden, die mit der Struktur des Substrat korreliert ist, d.h. direkt davon abhängt.

Die Belichtung, wie in 520 dargestellt, zeigt beispielhaft ein Belichten des optoelektronischen Bauteils mit schräg auftreffender bzw. eingestrahlter elektromagnetischer Strahlung gemäß mindestens einem der zuvor beschriebenen erfindungsgemäßen Verfahren 100, 200, 300. D.h. die Belichtung 503 kann aus unterschiedlichen Winkeln bzw. mit nicht-parallelen Lichtstrahlen erfolgen, um einen beliebig definierbaren Emissionsbereich 504 zu erzeugen.

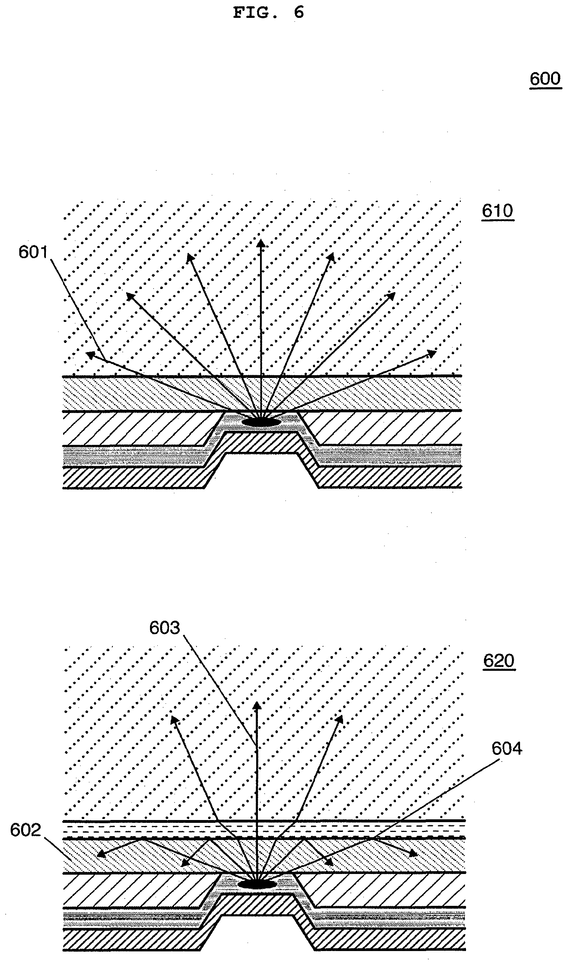

In Fig. 6 sind zwei exemplarische Querschnittsansichten von beispielhaften Ausführungsformen, die nicht gemäß der Erfindung gebildet sind, wobei das optoelektronisch aktive Bauteil 610 ausschließlich gemäß mindestens einem der zuvor beschriebenen Verfahren 100, 200, 300 gebildet wurde, wohingegen im optoelektronisch aktiven Bauteil 620 zwischen Substrat und der mindestens einen ersten Elektrode eine zusätzliche optisch niederbrechende Funktionsschicht 602 angeordnet ist. Diese zusätzliche optisch niederbrechende Funktionsschicht 602 ändert signifikant die Abstrahlcharakteristik des optoelektronisch aktiven Bauteils 620. Wird eine niederbrechende zusätzliche Funktionsschicht 602 zwischen Emitter 604 und Linsen eingefügt (vorzugsweise nahe am Emitter), kann das Winkelprofil der Strahlung im Substrat dahingehend beeinflusst werden, dass schräge Lichtstrahlen unterdrückt werden. Die verbleibenden schräg nach vorn gerichteten Lichtstrahlen 603 können durch die Linsen besser nach vorn ausgekoppelt werden, Streulicht hingegen wird unterdrückt. Wird auf der Rückseite der niederbrechenden Schicht eine Streuschicht eingefügt, kann die Leuchtdichte des Emitters durch Lichtrecycling erhöht werden. D.h. die reflektierende Rückelektrode aufgeraut bzw. strukturiert werden, der Übergang zur niederbrechenden Schicht kann aufgeraut bzw. strukturiert werden, um hier Streuung bzw.

Brechung zu erzielen und/oder optisch aktive Partikel können in aktive oder passive zusätzliche Funktionsschichten eingebracht werden.

**Patentansprüche**

1. Verfahren (100, 200, 300, 500, 600) zum Herstellen mindestens eines optoelektronischen aktiven Bauteils mittels Belichtens mit elektromagnetischer Strahlung, aufweisend:

   a) Bereitstellen mindestens eines Substrats mit einer Oberseite und einer Unterseite,

   i) wobei sich die Oberseite und die Unterseite gegenüberliegen,
   ii) wobei das Substrat mittels mindestens einer Schicht oder einem Schichtstapel, bestehend aus mindestens zwei übereinander angeordneten Schichten, gebildet ist,
   iii) wobei die Unterseite des Substrats mindestens eine erste Elektrodenschicht aufweist,
   iv) wobei die Oberseite mindestens eine Struktur aufweist, und
   v) wobei das Substrat und die erste Elektrodenschicht derart eingerichtet sind, dass das Substrat und die erste Elektrodenschicht zumindest gegenüber einem Wellenlängenbereich der elektromagnetischen Strahlung transparent oder transluzent sind (101);

   b) Aufbringen mindestens einer zusätzlichen ersten Schicht über der ersten Elektrodenschicht,

   i) wobei die erste zusätzliche Schicht derart eingerichtet ist, dass sie die elektromagnetische Strahlung zumindest teilweise absorbiert (102), und
   ii) wobei die elektrische Leitfähigkeit der ersten zusätzlichen Schicht in deren Volumen und/oder am Übergang zu mindestens einer angrenzenden Schicht geändert wird;

   c) Belichten der zusätzlichen ersten Schicht durch das Substrat und die erste Elektrodenschicht hindurch mit der elektromagnetischen Strahlung,

   i) wobei die elektromagnetische Strahlung beim Auftreffen auf die Struktur gebrochen oder gebeugt wird, wodurch mindestens zwei Bereiche mit unterschiedlicher Belichtungsintensität in der zusätzlichen ersten Schicht gebildet werden (103),
   ii) wobei die Intensitäten der Belichtung über der Struktur inhomogen sind, und
   iii) wobei die Belichtung abhängig vom Ort mit unterschiedlichem Einstrahlwinkel und/oder unterschiedlicher Intensität erfolgt;

   d) Aufbringen mindestens einer zusätzlichen zweiten Elektrodenschicht zumindest teilweise über der zusätzlichen ersten Schicht (104).

2. Verfahren (100, 200, 300, 500, 600) gemäß Anspruch 1, wobei die Struktur eine Oberfläche mindestens einer fokussierenden Mikrolinse umfasst.

3. Verfahren (100, 200, 300, 500, 600) gemäß Anspruch 2, wobei jede der mindestens einen Mikrolinse eine Brennweite gleich dem jeweiligen Abstand zwischen Oberseite und Unterseite des Substrats im Bereich der jeweiligen Mikrolinse plus minus 25% aufweist.

4. Verfahren (100, 200, 300, 500, 600) gemäß mindestens einem der vorgenannten Ansprüche, wobei die Belichtung der Struktur mit einer kollimierten elektromagnetischen Strahlung erfolgt.

5. Verfahren (100, 200, 300, 500, 600) gemäß Anspruch 4, wobei die Belichtung der Struktur einem zuvor bestimmten unveränderlichen Einstrahlwinkel erfolgt.

6. Verfahren (100, 200, 300, 500, 600) gemäß mindestens einem der vorgenannten Ansprüche, wobei zumindest eine an die erste Elektrodenschicht angrenzende Schicht des Schichtstapels des Substrats einen geringeren Brechungsindex als die anderen Schichten des Schichtstapels aufweist.

**Claims**

1. Method (100, 200, 300, 500, 600) for producing at least one opto-electronically active component by exposure to electromagnetic radiation featuring:

   a) Providing of at least one substrate with an upper side and a bottom side,

   i) wherein upper and bottom side face each other
   ii) wherein the substrate is made ofiat least a layer or a stack of layers, consisting of at least two layers stacked upon each other
   iii) wherein the bottom side of the substrate contains at least a first electrode layer
   iv) wherein the upper side contains at least one structure and
   v) wherein the substrate and the first electrode layer are arranged in such a way that the substrate and the first electrode layer are at least transparent or translucent (101) towards one wave length range of the electromagnetic radiation.

b) Application of at least one additional first layer above the first electrode layer,

i) wherein the first additional layer is applied in such a way that it at least partly absorbs (102) the electromagnetic radiation and ii) wherein the electrical conductivity of the first additional layer is changed in its volume and/or at the transition to at least one adjacent layer;

c) Exposure of the additional first layer to electromagnetic radiation through the substrate and the first electrode layer

i) wherein the electromagnetic radiation is refracted or diffracted upon impinging on the structure, whereby at least two areas with different exposure intensities are generated (103) in the additional first layer, ii) wherein the intensities of exposure to radiation above the structure are inhomogeneous, and iii) wherein the exposure to radiation takes place in dependence on the location with a different angle of incidence and/or different intensity;

d) Application of at least one additional second electrode layer at least partly above the additional first layer (104) .

2. Method (100, 200, 300, 500, 600) according to Claim 1, wherein the structure comprises the surface of at least one focussing micro lense.

3. Method (100, 200, 300, 500, 600) according to Claim 2, wherein each of the at least one micro lenses comprises a focal length equal to the respective distance between upper and bottom side of the substrate in the range of the respective micro lense plus minus 25 % percent.

4. Method (100, 200, 300, 500, 600) according to at least one of the above mentioned claims, wherein the exposure of the structure is carried out with a collimated electromagnetic radiation.

5. Method (100, 200, 300, 500, 600) according Claim 4, wherein the exposure of the structure is carried out with a pre-elected invariant angle of incidence.

6. Method (100, 200, 300, 500, 600) according to at least one of the above mentioned claims, wherein at least one layer of the stack of layers adjacent to the first electrode layer comprises a decreased index of refraction than the other layers of the stack of layers.

**Revendications**

1. Procédé (100, 200, 300, 500, 600) de fabrication d'au moins un composant optoélectronique actif par exposition à un rayonnement électromagnétique comprenant :

a) préparer au moins un substrat avec une face supérieure et une face inférieure,

i) les faces supérieure et inférieure étant localisées de part et d'autre du substrat ii) le substrat étant formé d'au moins une couche ou d'un empilement de couches, constitué d'au moins deux couches empilées l'une sur l'autre, iii) la face inférieure du substrat comprenant au moins une première couche d'électrode, iv) la face supérieure comprenant au moins une structure, et v) le substrat et la première couche d'électrode étant disposés de telle sorte que le substrat et la première couche d'électrode sont transparents ou translucides (101) au moins dans un domaine de longueurs d'onde du rayonnement électromagnétique ;

b) appliquer au moins une première couche supplémentaire au-dessus de la première couche d'électrode,

i) la première couche supplémentaire étant disposée de telle sorte qu'elle absorbe au moins partiellement (102) le rayonnement électromagnétique et ii) la conductivité électrique de la première couche supplémentaire étant modifiée dans son volume et/ou lors de la transition vers au moins une couche adjacente ;

c) exposer la première couche supplémentaire au rayonnement électromagnétique à travers le substrat et la première couche d'électrode

i) le rayonnement électromagnétique étant réfracté ou diffracté lorsqu'il atteint la structure, entraînant la formation d'au moins deux domaines d'intensités d'exposition différentes dans la première couche supplémentaire (103), ii) les intensités d'exposition au rayonnement au-dessus de la structure étant inhomogènes, et iii) l'exposition au rayonnement ayant lieu avec un angle d'incidence différent et/ou une intensité différente en fonction de l'emplacement ;

d) appliquer au moins une deuxième couche d'électrode supplémentaire au moins partiellement au-dessus de la première couche supplémentaire (104).

2. Procédé (100, 200, 300, 500, 600) conforme à la revendication 1, selon lequel la structure comprend une surface d'au moins une micro-lentille focalisante.

3. Procédé (100, 200, 300, 500, 600) conforme à la revendication 2, selon lequel chacune des au moins une micro-lentille présente une distance focale égale à la distance respective entre la face supérieure et la face inférieure du substrat dans le domaine de la micro-lentille respective plus moins 25 %.

4. Procédé (100, 200, 300, 500, 600) conforme au moins à l'une des revendications précédentes, selon lequel l'exposition au rayonnement de la structure est effectuée avec un rayonnement électromagnétique collimaté.

5. Procédé (100, 200, 300, 500, 600) conforme à la revendication 4, selon lequel l'exposition au rayonnement de la structure est effectuée avec un angle d'incidence invariant déterminé préalablement.

6. Procédé (100, 200, 300, 500, 600) conforme au moins à l'une des revendications précédentes, selon lequel au moins une couche de l'empilement de couches adjacente à la première couche d'électrode présente un indice de réfraction plus faible que celui des autres couches de l'empilement de couches.

FIG. 1

100

**101** — Bereitstellen mindestens eines Substrats mit einer Oberseite und einer Unterseite,

i) wobei sich die Oberseite und die Unterseite gegenüberliegen,

ii) wobei das Substrat mittels mindestens einer Schicht oder einem Schichtstapel, bestehend aus mindestens zwei übereinander angeordneten Schichten, gebildet ist,

iii) wobei die Unterseite des Substrats mindestens eine erste Elektrodenschicht aufweist,

iv) wobei die Oberseite mindestens eine Struktur aufweist, und

v) wobei das Substrat und die erste Elektrodenschicht derart eingerichtet sind, dass das Substrat und die erste Elektrodenschicht zumindest gegenüber einem Wellenlängenbereich der elektromagnetischen Strahlung transparent oder transluzent sind

**102** — Aufbringen mindestens einer zusätzlichen ersten Schicht über der ersten Elektrodenschicht,

i) wobei die erste zusätzliche Schicht derart eingerichtet ist, dass sie die elektromagnetische Strahlung zumindest teilweise absorbiert

**103** — Belichten der zusätzlichen ersten Schicht durch das Substrat und die erste Elektrodenschicht hindurch mit der elektromagnetischen Strahlung,

i) wobei die elektromagnetische Strahlung beim Auftreffen auf die Struktur gebrochen oder gebeugt wird, wodurch mindestens zwei Bereiche mit unterschiedlicher Belichtungsintensität in der zusätzlichen ersten Schicht gebildet werden

**104** — Aufbringen mindestens einer zusätzlichen zweiten Elektrodenschicht zumindest teilweise über der zusätzlichen ersten Schicht.

# FIG. 2

<u>200</u>

**201** — Bereitstellen mindestens eines Substrats mit einer Oberseite und einer Unterseite,

i) wobei sich die Oberseite und die Unterseite gegenüberliegen,

ii) wobei das Substrat mittels mindestens einer Schicht oder einem Schichtstapel, bestehend aus mindestens zwei übereinander angeordneten Schichten, gebildet ist,

iii) wobei die Unterseite des Substrats mindestens eine erste Elektrodenschicht aufweist,

iv) wobei die Oberseite mindestens eine Struktur aufweist, und

v) wobei das Substrat und die erste Elektrodenschicht derart eingerichtet sind, dass das Substrat und die erste Elektrodenschicht zumindest gegenüber einem Wellenlängenbereich der elektromagnetischen Strahlung transparent oder transluzent sind

**202** — Aufbringen mindestens einer zusätzlichen ersten Schicht über der ersten Elektrodenschicht,

i) wobei die erste zusätzliche Schichtmit einem Negativlack oder einem Positivlack gebildet ist

**203** — Belichten der zusätzlichen ersten Schicht durch das Substrat und die erste Elektrodenschicht hindurch mit der elektromagnetischen Strahlung,

i) wobei die elektromagnetische Strahlung beim Auftreffen auf die Struktur gebrochen oder gebeugt wird, wodurch mindestens zwei Bereiche mit unterschiedlicher Belichtungsintensität in der zusätzlichen ersten Schicht gebildet werden

**204** — Selektives Entfernen zumindest teilweise einer der Bereiche mit unterschiedlicher Belichtungsdosis vor dem Aufbringen der zweiten Elektrodenschicht,

i) wobei in diesem Bereich die jeweils darunter liegende Schicht zumindest teilweise freigelegt ist.

**205** — Aufbringen mindestens einer zusätzlichen zweiten Elektrodenschicht zumindest teilweise über der zusätzlichen ersten Schicht.

## FIG. 3

300

**301**
Bereitstellen mindestens eines Substrats mit einer Oberseite und einer Unterseite,

i) wobei sich die Oberseite und die Unterseite gegenüberliegen,

ii) wobei das Substrat mittels mindestens einer Schicht oder einem Schichtstapel, bestehend aus mindestens zwei übereinander angeordneten Schichten, gebildet ist,

iii) wobei die Unterseite des Substrats mindestens eine erste Elektrodenschicht aufweist,

iv) wobei die Oberseite mindestens eine Struktur aufweist, und

v) wobei das Substrat und die erste Elektrodenschicht derart eingerichtet sind, dass das Substrat und die erste Elektrodenschicht zumindest gegenüber einem Wellenlängenbereich der elektromagnetischen Strahlung transparent oder transluzent sind

**302**
Aufbringen mindestens einer zusätzlichen ersten Schicht über der ersten Elektrodenschicht,

i) wobei die erste zusätzliche Schicht derart eingerichtet ist, dass sie die elektromagnetische Strahlung zumindest teilweise absorbiert

**303**
Belichten der zusätzlichen ersten Schicht durch das Substrat und die erste Elektrodenschicht hindurch mit der elektromagnetischen Strahlung,

i) wobei die elektromagnetische Strahlung beim Auftreffen auf die Struktur gebrochen oder gebeugt wird, wodurch mindestens zwei Bereiche mit unterschiedlicher Belichtungsintensität in der zusätzlichen ersten Schicht gebildet werden

ii) wobei die erste Schicht nur bei einer der beiden unterschiedlichen Belichtungsintensitäten bei der Belichtung thermisch vor dem Aufbringen der zweiten Elektrodenschicht selektiv entfernt wird, wodurch die jeweils darunter liegende Schicht zumindest teilweise freigelegt ist.

**304**
Aufbringen mindestens einer zusätzlichen zweiten Elektrodenschicht zumindest teilweise über der zusätzlichen ersten Schicht.

FIG. 4

400

a)

401
402
403

b)

404

c)

405
406

d)

407    408

e)

409    410

f)

411
412

**FIG. 5**

500

501

510

502

503

520

504

FIG. 6

<u>600</u>

<u>610</u>

601

<u>620</u>

603

604

602

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8125138 B2
- DE 19844302 A1
- US 5666176 A
- US 7011420 B2
- US 6570324 B1
- US 6967779 B2
- JP 2006318807 A
- JP 2009272066 A

**In der Beschreibung aufgeführte Nicht-Patentliteratur**

- **P. MELPIGNANO ; V. BIONDO ; S. SINESI ; MICHAEL T. GALE ; SUSANNE WESTENHÖFER ; M. MURGIA ; S. CARIA ; R. ZAMBONI.** Efficient light extraction and beam shaping from flexible, optically integrated organic light-emitting diodes. *Applied Physics Letters,* 2006, vol. 88 (15
- **P. MELPIGNANO ; S. SINESI ; G. ROTARIS ; M. ANTONIPIERI ; F. CICOIRA ; M.A. LOI ; M. MUCCINI ; R. ZAMBONI ; M.T. GALE ; S. WESTENHÖFER.** Optical coupling of flexible microstructured organic light sources for automotive applications.'' Synthetic Metals. *Proceedings of the Fifth International Topical Conference on Optical Probes of Conjugated Polymers and Organic and Inorganic Nanostructures,* 2003, vol. 139 (3), 913-916

- **NORBERT DANZ ; CHRISTOPH A. WÄCHTER ; DIRK MICHAELIS ; PETER DANNBERG ; MICHAEL FLÄMMICH.** Micro optical pattern shaping for tailored light emission from organic leds. *Opt. Express,* Juni 2012, vol. 20 (12), 12682-12691
- **MICHAEL FLÄMMICH ; DIRK MICHAELIS ; NORBERT DANZ ; CHRISTOPH A. WÄCHTER ; PETER DANNBERG ; ANDREAS H. BRÄUER.** *Micro-optical beam-shaper for tailoring light emission from oleds,* 2010